# EUROPEAN PATENT APPLICATION

(11) **EP 4 730 967 A1**
(43) Date of publication of application: **22.04.2026**
(21) Application number: 25204851.7
(22) Date of filing: 26.09.2025
(51) Int. Cl.: H10K 50/858, H10K 50/86

(54) **ELECTRONIC DEVICE**

(30) Priority: 15.10.2024 CN 202411435279; 24.12.2024 CN 202411908663
(71) Applicant: InnoLux Corporation, Jhu-Nan, Miao-Li County 350 (TW)
(72) Inventor: LI, Wen-Tse, 350 Miao-Li County (TW); LIAO, Shih-Fu, 350 Miao-Li County (TW); YAO, I-An, 350 Miao-Li County (TW)
(74) Representative: Straus, Alexander

(57) **Abstract**

An electronic device (ED) includes a substrate (SB1), a light emitting unit (LU) disposed on the substrate (SB1) and used to emit a light (L1), a microlens (ML) disposed corresponding to the light emitting unit (LU) and used to concentrate the light (L1), and a light absorbing layer (AB). The light absorbing layer (AB) defines a light channel (LH) located between the light emitting unit (LU) and the microlens (ML), and the light channel (LH) is used to guide the light (L1) to the microlens (ML). A length (N1) of the light channel (LH) is greater than or equal to 60% of a distance (N2) between the light emitting unit (LU) and the microlens (ML).

## Description

### Field of the Disclosure

The present disclosure relates to an electronic device, and more particularly to an electronic device including microlens.

### Background of the Disclosure

In current organic light emitting diode display devices or liquid crystal display devices, the display device may for example have a narrow viewing angle by attaching a light control film to the outside of the display device. However, the above-mentioned design may reduce the brightness of the display device and affect the display effect of the display device. Therefore, to make the display device have a narrow viewing angle by other ways is still an important issue in the present field.

### Summary of the Disclosure

This is in mind, the present disclosure aims at providing an electronic device with an improved light emitting effect and/or a narrow viewing angle.

This is achieved by an electronic device according to the claims. The dependent claims pertain to corresponding further developments and improvements.

As will be seen more clearly from the detailed description following below, an electronic device is provided by the present disclosure. The electronic device includes a substrate, a light emitting unit, a microlens and a light absorbing layer. The light emitting unit is disposed on the substrate and used to emit a light. The microlens is disposed corresponding to the light emitting unit and used to concentrate the light. The light absorbing layer defines a light channel located between the light emitting unit and the microlens, and the light channel is used to guide the light to the microlens. A length of the light channel is greater than or equal to 60% of a distance between the light emitting unit and the microlens.

In addition, an electronic device is provided by the present disclosure. The electronic device includes a substrate, a light emitting unit, a microlens and a light absorbing layer. The light emitting unit is disposed on the substrate and used to emit a light. The microlens is disposed corresponding to the light emitting unit and used to concentrate the light. The light absorbing layer defines a light channel, wherein the microlens is disposed in the light channel. A length of the light channel is greater than or equal to a height of the microlens.

These and other objectives of the present disclosure will no doubt become obvious to those of ordinary skill in the art after reading the following detailed description of the embodiment that is illustrated in the various figures and drawings.

### Brief Description of the Drawings

In the following, the disclosure is further illustrated by way of example, taking reference to the accompanying drawings. Thereof:
FIG. 1 schematically illustrates a cross-sectional view of an electronic device according to a first embodiment of the present disclosure;
FIG. 2 schematically illustrates a cross-sectional view of an electronic device according to a variant embodiment of the first embodiment of the present disclosure;
FIG. 3 schematically illustrates a cross-sectional view of an electronic device according to a variant embodiment of the first embodiment of the present disclosure;
FIG. 4 schematically illustrates a cross-sectional view of an electronic device according to a variant embodiment of the first embodiment of the present disclosure;
FIG. 5 schematically illustrates a cross-sectional view of an electronic device according to a variant embodiment of the first embodiment of the present disclosure;
FIG. 6 schematically illustrates a cross-sectional view of an electronic device according to a second embodiment of the present disclosure;
FIG. 7 schematically illustrates a cross-sectional view of an electronic device according to a variant embodiment of the second embodiment of the present disclosure;
FIG. 8 schematically illustrates a cross-sectional view of an electronic device according to a variant embodiment of the second embodiment of the present disclosure;
FIG. 9 schematically illustrates a cross-sectional view of an electronic device according to a variant embodiment of the second embodiment of the present disclosure;
FIG. 10 schematically illustrates a cross-sectional view of an electronic device according to a variant embodiment of the second embodiment of the present disclosure;
FIG. 11 schematically illustrates a cross-sectional view of an electronic device according to a third embodiment of the present disclosure;
FIG. 12 schematically illustrates a cross-sectional view of an electronic device according to a variant embodiment of the third embodiment of the present disclosure;
FIG. 13 schematically illustrates a cross-sectional view of an electronic device according to a variant embodiment of the third embodiment of the present disclosure;
FIG. 14 schematically illustrates a cross-sectional view of an electronic device according to a variant embodiment of the third embodiment of the present disclosure;
FIG. 15 schematically illustrates a cross-sectional view of an electronic device according to a fourth embodiment of the present disclosure;
FIG. 16 schematically illustrates a cross-sectional view of an electronic device according to a fifth embodiment of the present disclosure;
FIG. 17 schematically illustrates a cross-sectional view of an electronic device according to a variant embodiment of the fifth embodiment of the present disclosure;
FIG. 18 schematically illustrates a top view of an electronic device according to a sixth embodiment of the present disclosure; and
FIG. 19 schematically illustrates a top view of an electronic device according to a seventh embodiment of the present disclosure.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the device, and certain elements in various drawings may not be drawn to scale. In addition, the number and dimension of each element shown in drawings are only illustrative and are not intended to limit the scope of the present disclosure.

Certain terms are used throughout the description and following claims to refer to particular elements. As one skilled in the art will understand, electronic equipment manufacturers may refer to an element by different names. This document does not intend to distinguish between elements that differ in name but not function.

In the following description and in the claims, the terms "include", "comprise" and "have" are used in an open-ended fashion, and thus should be interpreted to mean "include, but not limited to...".

It will be understood that when an element or layer is referred to as being "disposed on" or "connected to" another element or layer, it can be directly on or directly connected to the other element or layer, or intervening elements or layers may be presented (indirectly). In contrast, when an element is referred to as being "directly on" or "directly connected to" another element or layer, there are no intervening elements or layers presented. When an element or a layer is referred to as being "electrically connected" to another element or layer, it can be a direct electrical connection or an indirect electrical connection. The electrical connection or coupling described in the present disclosure may refer to a direct connection or an indirect connection. In the case of a direct connection, the ends of the elements on two circuits are directly connected or connected to each other by a conductor segment. In the case of an indirect connection, switches, diodes, capacitors, inductors, resistors, other suitable elements or combinations of the above elements may be included between the ends of the elements on two circuits, but not limited thereto.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

According to the present disclosure, the thickness, length and width may be measured through optical microscope, and the thickness or width may be measured through the cross-sectional view in the electron microscope, but not limited thereto.

In addition, any two values or directions used for comparison may have certain errors. In addition, the terms "equal to", "equal", "the same", "approximately" or "substantially" are generally interpreted as being within ± 10%, ± 5%, ± 3%, ± 2%, ± 1%, or ± 0.5% of the given value.

In addition, the terms "the given range is from a first value to a second value" or "the given range is located between a first value and a second value" represents that the given range includes the first value, the second value and other values there between.

If a first direction is said to be perpendicular to a second direction, the included angle between the first direction and the second direction may be located between 80 to 100 degrees. If a first direction is said to be parallel to a second direction, the included angle between the first direction and the second direction may be located between 0 to 10 degrees.

Unless it is additionally defined, all terms (including technical and scientific terms) used herein have the same meaning as commonly understood by those ordinary skilled in the art. It can be understood that these terms that are defined in commonly used dictionaries should be interpreted as having meanings consistent with the relevant art and the background or content of the present disclosure, and should not be interpreted in an idealized or overly formal manner, unless it is specifically defined in the embodiments of the present disclosure.

It should be noted that the technical features in different embodiments described in the following can be replaced, recombined, or mixed with one another to constitute another embodiment without departing from the spirit of the present disclosure.

The electronic device of the present disclosure may include a display device, a sensing device, a back-light device, an antenna device, a tiled device, a virtual reality product or other suitable electronic devices, but not limited thereto. The electronic device of the present disclosure may be a foldable electronic device, a flexible electronic device or a stretchable electronic device. The display device may include a non-self-emissive display device or a self-emissive display device. The non-self-emissive display device for example includes a liquid crystal display device, but not limited thereto. The self-emissive display device for example includes a light emitting diode display device, but not limited thereto. The display device may for example be applied to laptops, common displays, tiled displays, vehicle displays, touch displays, televisions, monitors, smart phones, tablets, light source modules, lighting devices or electronic devices applied to the products mentioned above, but not limited thereto. The sensing device may include a biosensor, a touch sensor, a fingerprint sensor, other suitable sensors or combinations of the above-mentioned sensors. The antenna device may for example include a liquid crystal antenna device, but not limited thereto. The tiled device may for example include a tiled display device or a tiled antenna device, but not limited thereto. The outline of the electronic device may be a rectangle, a circle, a polygon, a shape with curved edge or other suitable shapes. The electronic device may include electronic units, wherein the electronic units may include passive elements or active elements, such as capacitor, resistor, inductor, diode, transistor, sensors, and the like. The diode may include a light emitting diode or a photo diode. The light emitting diode may for example include an organic light emitting diode (OLED) or an inorganic light emitting diode. The inorganic light emitting diode may for example include a mini light emitting diode (mini LED), a micro light emitting diode (micro LED) or a quantum dot light emitting diode (QLED), but not limited thereto. The electronic device may include peripheral systems such as driving systems, controlling systems, light source systems to support display devices, antenna devices, wearable devices (such as augmented reality devices or virtual reality devices), vehicle devices (such as windshield of car) or tiled devices.

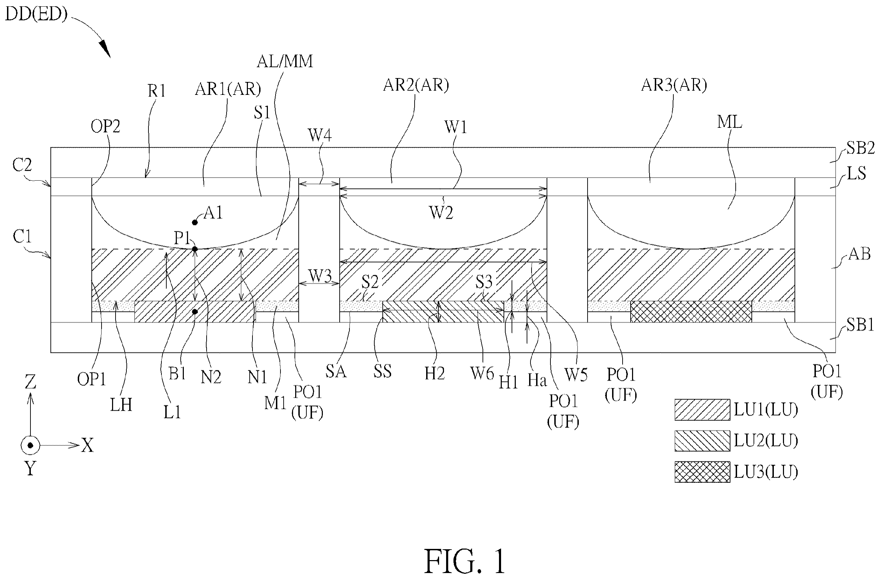

Referring to FIG. 1, FIG. 1 schematically illustrates a cross-sectional view of an electronic device according to a first embodiment of the present disclosure. The electronic device ED of the present disclosure may for example include a display device DD for displaying images or pictures, but not limited thereto. In some embodiments, the electronic device ED may include combinations of the display device DD and other suitable electronic devices. According to the present embodiment, the electronic device ED may include a first substrate SB1, light emitting units LU, a light absorbing layer AB, microlenses ML and a second substrate SB2, but not limited thereto. Specifically, the first substrate SB1 and the second substrate SB2 may be located at two opposite sides of the electronic device ED, and the elements and the layers such as the light emitting units LU, the light absorbing layer AB and the microlenses ML are located between the first substrate SB1 and the second substrate SB2. The structures of the elements and the layers of the electronic device ED will be detailed in the following.

According to the present embodiment, the first substrate SB1 may include an array substrate. Specifically, the first substrate SB1 may include a multi-layer structure and include a circuit layer. For example, although it is not shown in FIG. 1, the first substrate SB1 may include a base and a circuit layer disposed on the base. The base may be used to support the elements and the layers disposed thereon. The base may include rigid materials or flexible materials. The rigid materials for example include glass, quartz, sapphire, ceramic, other suitable materials or combinations of the above-mentioned materials. The flexible materials for example include polyimide (PI), polycarbonate (PC), polyethylene terephthalate (PET), other suitable materials or combinations of the above-mentioned materials. The base may include a single layer structure or a multi-layer structure. The circuit layer may include various kinds of wires, circuits or electronic units that can be applied to the electronic device ED. The electronic unit may include any suitable active element and/or passive element. The circuit layer may for example include any suitable structure formed by stacking conductive layer(s) and insulating layer(s), wherein the conductive layer(s) may be used for forming the wires, the circuits or the electronic units mentioned above, but not limited thereto. For example, the circuit layer may include driving units, wherein the driving units may be electrically connected to the light emitting units LU, thereby controlling light emission of the light emitting units LU, but not limited thereto. The driving unit may for example include thin film transistor (TFT) elements, but not limited thereto. It should be noted that according to the structural design of the electronic device ED, the wires, the circuits and the electronic units in the circuit layer may further be electrically connected to other suitable electronic elements in the electronic device ED.

According to the present embodiment, the light absorbing layer AB may be disposed on the first substrate SB1. Specifically, the light absorbing layer AB may be disposed at a side of the circuit layer opposite to the base. The light absorbing layer AB may directly contact the first substrate SB1, or directly contact the circuit layer, but not limited thereto. In other embodiments, other layers may be included between the light absorbing layer AB and the circuit layer. The light absorbing layer AB may include (or define) a plurality of openings OP1, and the light emitting units LU may be disposed in the openings OP1. For example, a light emitting unit LU may be disposed in an opening OP1. Specifically, the opening OP1 may expose the conductive element (such as the bonding pad) of the circuit layer, such that the light emitting unit LU disposed in the opening OP1 may be electrically connected to the circuit layer (for example, the driving unit in the circuit layer) through the conductive element. The light absorbing layer AB may include any suitable light absorbing material, such as black photoresist, black printing ink, black resin, gray resin, other suitable materials or combinations of the above-mentioned materials. The light absorbing layer AB may separate the light emitting units LU. In such condition, the light absorbing layer AB may be regarded as a pixel defining layer (PDL).

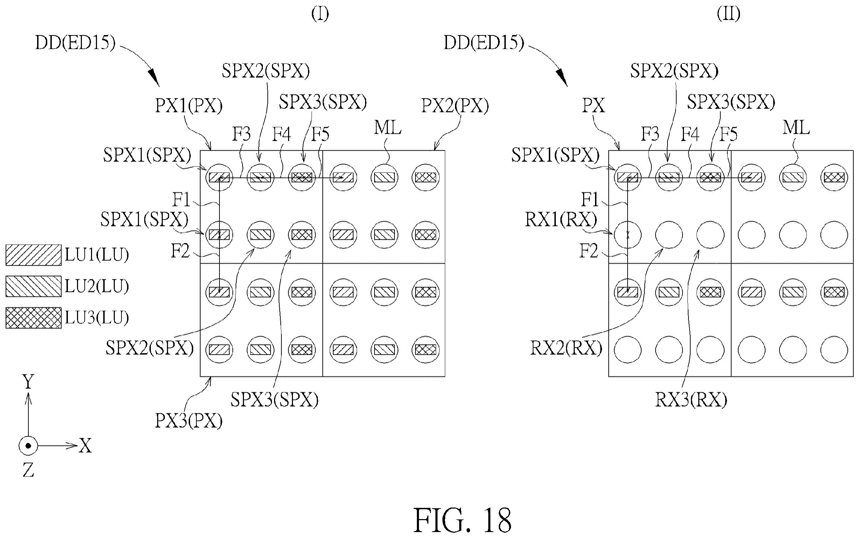

The light emitting units LU may be disposed on the first substrate SB1 and located in the openings OP1 of the light absorbing layer AB. The light emitting units LU may directly contact the first substrate SB1 (for example, directly contact the circuit layer), but not limited thereto. In other embodiments, other layers may be included between the light emitting units LU and the first substrate SB1. The light emitting unit LU may include a light emitting diode, but not limited thereto. The light emitting diode may include an organic light emitting diode (OLED), a quantum dot light emitting diode (QLED), an inorganic light emitting diode, or combinations of the above-mentioned elements. The inorganic light emitting diode may include a mini light emitting diode (mini LED) or a micro light emitting diode (micro LED), but not limited thereto. For example, the light emitting unit LU of the present embodiment may include micro light emitting diode. In the present embodiment, the light emitting units LU may be arranged in an array, but not limited thereto. For example, the light emitting units LU may be arranged in an array along a direction X and a direction Y (not shown in FIG. 1). Or, FIG. 18 also shows the structure that the light emitting units LU are arranged in an array. In such condition, the light absorbing layer AB may have a grid structure, and the openings OP1 may be arranged in an array along the direction X and the direction Y. In other embodiments, the light emitting units LU may be arranged in other ways, based on the structural design of the electronic device ED. In the present embodiment, the light emitting units LU may include a light emitting unit LU1, a light emitting unit LU2 and a light emitting unit LU3, but not limited thereto. The light emitting unit LU1, the light emitting unit LU2 and the light emitting unit LU3 may respectively emit light of different colors. For example, the light emitting unit LU1, the light emitting unit LU2 and the light emitting unit LU3 may respectively emit a red light, a green light and a blue light which can be mixed into a white light in the present embodiment. In such condition, the light emitting unit LU1, the light emitting unit LU2 and the light emitting unit LU3 may respectively be included in three sub-pixels, and these three sub-pixels may form a pixel. The number of light emitting units LU in a pixel of the electronic device ED is not limited to three, which depends on the demand of the design of the electronic device ED. FIG. 1 just exemplarily shows the structure including one light emitting unit, one light emitting unit LU2 and one light emitting unit LU3 (that is, a pixel), and the electronic device ED may include a plurality of light emitting units LU1, a plurality of light emitting units LU2 and a plurality of light emitting units LU3.

According to the present embodiment, the electronic device ED may further include an underfill layer UF disposed on the first substrate SB1. The underfill layer UF may contact the first substrate SB1, or in other words, the underfill layer UF may contact the circuit layer of the first substrate SB1, but not limited thereto. Specifically, the underfill layer UF may be disposed on the first substrate SB1 and surround the light emitting unit LU, such that the light emitting unit LU may be fixed on the first substrate SB1. "The underfill layer UF surrounds the light emitting unit LU" described herein may represent that the underfill layer UF covers at least a portion of the side surface SS of the light emitting unit LU. Specifically, in some embodiments, the underfill layer UF may not completely cover the side surface SS of the light emitting unit LU, as shown in FIG. 1. In such condition, the top surface SA (or the surface away from the first substrate SB1) of the underfill layer UF may be lower than the top surface S3 of the light emitting unit LU. In some embodiments, the top surface SA of the underfill layer UF may substantially be aligned with the top surface S3 of the light emitting unit LU, that is, the side surface SS of the light emitting unit LU may be completely covered by the underfill layer UF. It should be noted that in the present embodiment, the top surface SA of the underfill layer UF may not be higher than the top surface S3 of the light emitting unit LU, or the underfill layer UF may not cover the top surface S3 of the light emitting unit LU. The underfill layer UF may include any suitable insulating material, such as epoxy resin, acrylic resin, other suitable materials or combinations of the above-mentioned materials.

In the present embodiment, the underfill layer UF may be disposed in the openings OP1 of the light absorbing layer AB, but not limited thereto. For example, the light absorbing layer AB may be disposed on the first substrate SB1, and the light emitting units LU may be disposed in the openings OP1 of the light absorbing layer AB at first, and then the underfill layer UF may be disposed in the openings OP1 and surround the light emitting units LU. In such condition, the underfill layer UF may include a plurality of portions PO1, wherein the portions PO1 are respectively disposed in the openings OP1 and surround the light emitting units LU. Specifically, one of the portions PO1 may be disposed in one of the openings OP1 and surround one of the light emitting units LU. In addition, the light absorbing layer AB may be located between two adjacent portions PO1, or the light absorbing layer AB may separate two adjacent portions PO1.

According to the present embodiment, the electronic device ED may further include a light shielding layer LS and a plurality of anti-reflection layers AR, but not limited thereto. The light shielding layer LS is located on the light absorbing layer AB, or in other words, the light shielding layer LS is located at a side of the light absorbing layer AB opposite to the first substrate SB1. The light shielding layer LS may directly contact the light absorbing layer AB. The anti-reflection layers AR may be disposed corresponding to the light emitting units LU. Specifically, an anti-reflection layer AR may be disposed corresponding to a light emitting unit LU. In detail, the light shielding layer LS may have a pattern the same as or similar to the pattern of the light absorbing layer AB, and the light shielding layer LS may be disposed corresponding to the light absorbing layer AB. For example, the light shielding layer LS and the light absorbing layer AB may both have a grid pattern in the top view of the electronic device ED, but not limited thereto. In such condition, the light shielding layer LS may overlap the light absorbing layer AB in the normal direction (that is, the direction Z) of the electronic device ED. Specifically, in a cross-sectional view of the electronic device ED, the light absorbing layer AB may include a plurality of columnar portions C1, and the light shielding layer LS may include a plurality of columnar portions C2, wherein the columnar portions C1 respectively correspond to the columnar portions C2. The light shielding layer LS may include (or define) a plurality of openings OP2, and the anti-reflection layers AR may respectively be disposed in the openings OP2. One of the openings OP2 of the light shielding layer LS may correspond to one of the openings OP1 of the light absorbing layer AB. Therefore, the anti-reflection layers AR disposed in the openings OP2 may correspond to the light emitting units LU disposed in the openings OP1. The material of the light shielding layer LS may refer to the material of the light absorbing layer AB mentioned above. It should be noted that the material of the light shielding layer LS may be the same as or different from the material of the light absorbing layer AB. The anti-reflection layer AR may be used to absorb ambient light entering the electronic device ED, thereby increasing ambient contrast ratio. The anti-reflection layer AR may include any suitable element or layer that can reduce reflection. In the present embodiment, the anti-reflection layer AR may include a color filter, but not limited thereto. Specifically, an anti-reflection layer AR may include a color filter having the color corresponding to the color of the light emitted by the light emitting unit LU to which the anti-reflection layer AR corresponds. For example, the light emitting unit LU1 may emit red light, and the anti-reflection layer AR1 disposed corresponding to the light emitting unit LU1 may include a red color filter; the light emitting unit LU2 may emit green light, and the anti-reflection layer AR2 disposed corresponding to the light emitting unit LU2 may include a green color filter; the light emitting unit LU3 may emit blue light, and the anti-reflection layer AR3 disposed corresponding to the light emitting unit LU3 may include a blue color filter, but not limited thereto. In other embodiments, the anti-reflection layer AR may include other suitable elements or materials to reduce reflection.

According to the present embodiment, the electronic device ED may include a plurality of microlenses ML, wherein the microlenses ML are disposed corresponding to the light emitting units LU respectively. For example, a microlens ML may be disposed corresponding to a light emitting unit LU, but not limited thereto. In other words, the electronic device ED may include a microlens array. Specifically, each of the microlenses ML may be disposed at a side of an anti-reflection layer AR facing the light emitting unit LU (for example, the side where the surface S1 of the anti-reflection layer AR is located) and correspond to the light emitting unit LU to which the anti-reflection layer AR corresponds. The microlens ML may be located between the anti-reflection layer AR and the light emitting unit LU. In addition, the microlens ML may have a convex surface, and the convex surface may face the light emitting unit LU. Moreover, the microlens ML may be located or at least partially located in the opening OP1, that is, the microlens ML may at least partially overlap the light absorbing layer AB in the direction X. The microlens ML may directly contact the surface S1 of the anti-reflection layer AR, but not limited thereto. In other embodiments, other layers may be included between the microlens ML and the anti-reflection layer AR. As shown in FIG. 1, through the above-mentioned structural design, an opening OP1 and the opening OP2 corresponding to the opening OP1 in the electronic device ED may form a region R1 surrounded by the first substrate SB1, the second substrate SB2, the light absorbing layer AB and the light shielding layer LS, and a group of the light emitting unit LU, the microlens ML and the anti-reflection layer AR corresponding to each other may be disposed in a region R1. The microlens ML may be used to concentrate the light emitted by the light emitting unit LU to which the microlens ML corresponds. For example, the light L1 emitted by the light emitting unit LU1 may be emitted to the microlens ML corresponding to the light emitting unit LU1 and be concentrated by the microlens ML.

According to the present embodiment, the disposition position of the microlens ML may be designed, such that the center of the microlens ML may overlap the center of the light emitting layer (not shown) of the light emitting unit LU, but not limited thereto. "The light emitting layer of the light emitting unit LU" described herein may include the element or the layer in the light emitting unit LU that is mainly used to generate light. In an embodiment, "the center of the microlens ML and the center of the light emitting layer of the light emitting unit LU" may respectively represent the geometric center of the shape of the microlens ML and the geometric center of the shape of the light emitting layer of the light emitting unit LU in a cross-sectional view of the electronic device ED. For example, as shown in FIG. 1, the geometric center of the cross-sectional shape of the microlens ML may fall at a point A1, and the geometric center of the cross-sectional shape of the light emitting layer of the light emitting unit LU may fall at a point B1, wherein the point A1 may correspond to the point B1, or the point A1 may overlap the point B1 in the normal direction of the electronic device ED. In another embodiment, "the center of the microlens ML and the center of the light emitting layer of the light emitting unit LU" may respectively represent the geometric center of the top view shape of the microlens ML and the geometric center of the top view shape of the light emitting layer of the light emitting unit LU in a top view of the electronic device ED.

According to the present embodiment, the disposition range of an anti-reflection layer AR may fall within the disposition range of the microlens ML to which the anti-reflection layer AR corresponds. Specifically, an anti-reflection layer AR may completely overlap the microlens ML to which the anti-reflection layer AR corresponds in the normal direction of the electronic device ED, or the microlens ML does not expose the surface S1 of the anti-reflection layer AR to which the microlens ML corresponds. In such condition, in a cross-sectional view of the electronic device ED (as shown in FIG. 1), an anti-reflection layer AR (the anti-reflection layer AR2 shown in FIG. 1 is taken as an example, but not limited thereto) may have a width W1, and the microlens ML corresponding to the anti-reflection layer AR may have a width W2, wherein the width W2 is greater than or equal to the width W1. The width W1 may for example be defined as the maximum width of the anti-reflection layer AR in a cross-sectional view of the electronic device ED. The width W2 may for example be defined as the maximum width of the microlens ML in a cross-sectional view of the electronic device ED, that is, the width of the microlens ML at a side adjacent to the anti-reflection layer AR. It should be noted that the widths W1 of different anti-reflection layers AR may be the same or different, and the widths W2 of different microlenses ML may be the same or different. In a cross-sectional view of the electronic device ED, the light absorbing layer AB may have a width W3, and the light shielding layer LS may have a width W4. The width W3 may be the maximum width of the columnar portion C1 of the light absorbing layer AB, and the width W4 may be the maximum width of the columnar portion C2 of the light shielding layer LS. The width W3 of the light absorbing layer AB may be less than or equal to the width W4 of the light shielding layer LS. In the present embodiment, as shown in FIG. 1, the width W3 of the light absorbing layer AB may be the same as the width W4 of the light shielding layer LS. In such condition, the width W2 of the microlens ML may be the same as the width W1 of the anti-reflection layer AR to which the microlens ML corresponds. Specifically, in a cross-sectional view of the electronic device ED, two ends of a columnar portion C1 of the light absorbing layer AB may be respectively aligned with two ends of a columnar portion C2 of the light shielding layer LS to which the columnar portion C1 corresponds, and two ends of a microlens ML may contact the light absorbing layer AB and be respectively aligned with two ends of the anti-reflection layer AR to which the microlens ML corresponds. In another embodiment, the width W3 of the light absorbing layer AB may be less than the width W4 of the light shielding layer LS. In such condition, the width W2 of the microlens ML may be greater than the width W1 of the anti-reflection layer AR to which the microlens ML corresponds. Specifically, in a cross-sectional view of the electronic device ED, two ends of a columnar portion C1 of the light absorbing layer AB may be retracted compared to two ends of a columnar portion C2 of the light shielding layer LS to which the columnar portion C1 corresponds, and two ends of a microlens ML may contact the light absorbing layer AB and respectively extend beyond two ends of the anti-reflection layer AR to which the microlens ML corresponds. In other words, in the normal direction of the electronic device ED, the microlens ML may at least partially overlap the light shielding layer LS.

According to the present embodiment, the electronic device ED includes a second substrate SB2 located on the light shielding layer LS and the anti-reflection layers AR. The second substrate SB2 may directly contact the light shielding layer LS and the anti-reflection layers AR, but not limited thereto. In other embodiments, other layers may be included between the second substrate SB2 and the light shielding layer LS and/or the anti-reflection layers AR. The second substrate SB2 may include a single layer structure or a multi-layer structure. In some embodiments, the second substrate SB2 may include a base, wherein the material of the base may refer to the material of the base of the first substrate SB1 mentioned above. The material of the base of the second substrate SB2 and the material of the base of the first substrate SB1 may be the same or different. In some embodiments, the second substrate SB2 may include combinations of the base and other suitable elements or layers such as an adhesive layer, an anti-reflection layer, an antifouling layer, a protecting layer, an optical layer, and the like, but not limited thereto.

According to the present embodiment, the electronic device ED may further include a first material layer M1 disposed on the first substrate SB1. Specifically, the first material layer M1 may be filled in the openings OP1 of the light absorbing layer AB and disposed on the underfill layer UF. In the present embodiment, the top surface S2 (or the surface away from the first substrate SB1) of the first material layer M1 may be aligned with the top surface S3 of the light emitting unit LU. Specifically, the first material layer M1 may have a height H1, the underfill layer UF may have a height Ha, and the light emitting unit LU may have a height H2, wherein the height H1 and the height Ha may be less than the height H2, and the sum of the height H1 and the height Ha is substantially the same as the height H2. In such condition, the underfill layer UF may cover a portion of the side surface SS of the light emitting unit LU, and the first material layer M1 may cover another portion of the side surface SS of the light emitting unit LU. In some embodiments, the top surface S2 of the first material layer M1 may be lower than the top surface S3 of the light emitting unit LU, that is, the sum of the height H1 of the first material layer M1 and the height Ha of the underfill layer UF may be less than the height H2 of the light emitting unit LU. The first material layer M1 may include glue materials (such as optical clear adhesive (OCA), but not limited thereto), photoresist materials or other suitable materials. The refractive index of the first material layer M1 may be greater than 1.0 and less than or equal to 1.8, but not limited thereto. In other words, a glue material or a photoresist material having a refractive index greater than 1.0 and less than or equal to 1.8 may serve as the material of the first material layer M1. In some embodiments, the refractive index of the first material layer M1 may be greater than or equal to 1.1 and less than or equal to 1.7. In some embodiments, the refractive index of the first material layer M1 may be greater than or equal to 1.2 and less than or equal to 1.6. In addition, the electronic device ED may include an air layer AL surrounded by the light absorbing layer AB and located between the microlens ML and the light emitting unit LU (or the first material layer M1). Specifically, the space of the opening OP1 of the light absorbing layer AB may further include air (or the air layer AL) in addition to the microlens ML, the light emitting unit LU, the first material layer M1 and/or the underfill layer UF. In some embodiments, the electronic device ED may not include the first material layer M1, that is, the air layer AL may contact the underfill layer UF and/or the light emitting unit LU. In some embodiments, the air layer AL of the electronic device ED may be replaced by other material layers. Specifically, the electronic device ED may further include a material layer MM disposed on the first material layer M1. The material layer MM may include a glue material or a photoresist material having a refractive index greater than or equal to 1.0 and less than or equal to the refractive index of the microlens ML. The material layer MM may include a single layer structure or a multi-layer structure. When the material layer MM includes a multi-layer structure, the material layer MM may be formed by stacking a plurality of glue materials or photoresist materials that meet the above-mentioned requirement of refractive index. The refractive index of the microlens ML may for example be greater than or equal to 1.5 and less than or equal to 2.0, but not limited thereto. It should be noted that "the material layer MM replaces the air layer AL" mentioned above may include the embodiment that the material layer MM at least partially replaces the air layer AL. For example, in an embodiment, the material layer MM may be disposed on the first material layer M1, and the air layer AL may be included between the material layer MM and the microlens ML.

According to the present embodiment, the electronic device ED may be formed by combining the first substrate SB1 and the second substrate SB2. Specifically, the first substrate SB1 may be provided at first, and then the patterned light absorbing layer AB having the plurality of openings OP1 may be disposed on the first substrate SB1, and then the light emitting units LU, the underfill layer UF and/or the first material layer M1 may be disposed in the openings OP1. In addition, the second substrate SB2 may be provided, the patterned light shielding layer LS having the plurality of openings OP2 may be disposed on the second substrate SB2, the anti-reflection layers AR may be disposed in the openings OP2, and the microlenses ML may be disposed on the anti-reflection layers AR. After that, the first substrate SB1 and the second substrate SB2 may be combined to form the electronic device ED shown in FIG. 1, wherein the light absorbing layer AB on the first substrate SB1 may correspond to the light shielding layer LS on the second substrate SB2, and one of the light emitting units LU on the first substrate SB1 may correspond to one of the anti-reflection layers AR and one of the microlenses ML on the second substrate SB2. It should be noted that the method for forming the electronic device ED of the present embodiment is not limited to the above-mentioned steps. In some embodiments, the light absorbing layer AB and the light shielding layer LS may both be formed on the first substrate SB1. In some embodiments, the light absorbing layer AB and the light shielding layer LS may both be formed on the second substrate SB2. In some embodiments, the light absorbing layer AB and the light shielding layer LS may be formed in the same process, for example, the light absorbing layer AB and the light shielding layer LS may be one-piece-formed.

According to the present embodiment, the electronic device ED may include a light channel LH defined by the light absorbing layer AB. Specifically, the region between the light emitting unit LU and the microlens ML in an opening OP1 of the light absorbing layer AB may be defined as the region of a light channel LH. In other words, the light channel LH may be surrounded by the light absorbing layer AB and may be located between the light emitting unit LU and the microlens ML. In detail, in a cross-sectional view of the electronic device ED, the region located between a point P1 of the microlens ML that is closest to the light emitting unit LU and the top surface S3 of the light emitting unit LU in the opening OP1 may be defined as the region of the light channel LH. In the present embodiment, the light channel LH may only include the air layer AL, but not limited thereto. In some embodiments, the light channel LH may further include the material layer MM mentioned above. The plurality of light channels LH may be defined in the plurality of openings OP1 of the light absorbing layer AB, and one of the light channels LH is located between a light emitting unit LU and the microlens ML to which the light emitting unit LU corresponds and may be used to guide the light emitted by the light emitting unit LU to the microlens ML. For example, as shown in FIG. 1, the light channel LH in the opening OP1 where the light emitting unit LU1 is disposed may be used to guide the light L1 emitted by the light emitting unit LU1 to the microlens ML corresponding to the light emitting unit LU1. The feature of the light channels in other openings OP1 shown in FIG. 1 may refer to the contents mentioned above, and will not be redundantly described.

According to the present embodiment, in an opening OP1, the light channel LH may have a length N1 in the normal direction of the electronic device ED, and a distance N2 may be included between the light emitting unit LU and the microlens ML corresponding to the light emitting unit LU in the normal direction of the electronic device ED, wherein the length N1 may be greater than or equal to 60% of the distance N2 (that is, N1≥0.6N2). The length N1 may be defined as the maximum length of the light channel LH in the normal direction of the electronic device ED. The distance N2 may be defined as the minimum distance between the light emitting unit LU and the microlens ML in the normal direction of the electronic device ED, such as the distance between the point P1 of the microlens ML and the top surface S3 of the light emitting unit LU. In some embodiments, the length N1 may be greater than or equal to 70% of the distance N2 (that is, N1≥0.7N2). In some embodiments, the length N1 may be greater than or equal to 80% of the distance N2 (that is, N1≥0.8N2). For example, the length N1 may be the same as the distance N2 in the present embodiment, but not limited thereto.

According to the present embodiment, in a cross-sectional view of the electronic device ED, the width of the light channel LH in an opening OP1 may be less than or equal to the width of the microlens ML corresponding to the opening OP1. For example, as shown in FIG. 1, in the opening OP1 where the light emitting unit LU2 is disposed, the light channel LH may have a width W5, wherein the width W5 may be less than or equal to the width (for example, the width W2) of the microlens ML corresponding to the opening OP1 where the light emitting unit LU2 is disposed. In a cross-sectional view of the electronic device ED, the width W5 of the light channel LH may be defined as the maximum width of the light channel LH. The widths of different light channels LH may be the same or different, it is not limited in the present embodiment. In some embodiments, the width W3 of the light absorbing layer AB is the same as the width W4 of the light shielding layer LS, and the width W2 of a microlens ML is the same as the width W1 of the anti-reflection layer AR to which the microlens ML corresponds. In such condition, the width W5 of the light channel LH corresponding to the microlens ML may be the same as the width W2 of the microlens ML. In some embodiments, the width W3 of the light absorbing layer AB may be less than the width W4 of the light shielding layer LS, and the width W2 of a microlens ML may be greater than the width W1 of the anti-reflection layer AR to which the microlens ML corresponds. In such condition, the width W5 of the light channel LH corresponding to the microlens ML may be less than the width W2 of the microlens ML. In addition, a difference between the width W5 of the light channel LH and the width W2 of the microlens ML may range from 5 micrometers (µm) to 15µm (that is, 5µm≤difference≤15µm), but not limited thereto. In some embodiments, the difference between the width W5 and the width W2 may range from 6µm to 14µm (that is, 6µm≤difference≤14µm). In some embodiments, the difference between the width W5 and the width W2 may range from 7µm to 13µm (that is, 7µm≤difference≤13µm). Through the above-mentioned design, the possibility that the microlens ML does not correspond to a portion of the anti-reflection layer AR due to process tolerance may be reduced. In addition, in a cross-sectional view of the electronic device ED, the width of the light channel LH in an opening OP1 may be greater than the width of the light emitting unit LU disposed in the opening OP1. For example, as shown in FIG. 1, the width W5 of the light channel LH in the opening OP1 where the light emitting unit LU2 is disposed may be greater than the width W6 of the light emitting unit LU2. In a cross-sectional view of the electronic device ED, the width W6 may be defined as the maximum width of the light emitting unit LU2.

Through the above-mentioned structural design of the electronic device ED, the light emitted by the light emitting unit LU may be guided to the microlens ML through the light channel LH, thereby being concentrated. In addition, through the above-mentioned length design of the light channel LH and the design of distance between the light emitting unit LU and the microlens ML, the interference between the lights emitted by different light emitting units LU may be reduced, or the possibility of the light emitted by a light emitting unit LU entering the microlens ML not corresponding to the light emitting unit LU may be reduced. Moreover, through the designs of the width of the light channel LH, the width of the microlens ML and the width of the light emitting unit LU, the possibility of the light emitted by the light emitting unit LU not entering the microlens ML may be reduced. Therefore, the electronic device ED may have a narrow viewing angle, or the light emitting effect of the electronic device ED may be improved.

It should be noted that the electronic device ED of the present embodiment may further include other suitable elements or layers and is not limited to what is shown in FIG. 1. Other embodiments of the present disclosure will be described in the following. In order to simplify the description, the same elements or layers in the following embodiments would be labeled with the same symbol, and the features thereof will not be redundantly described. The differences between the embodiments will be detailed in the following.

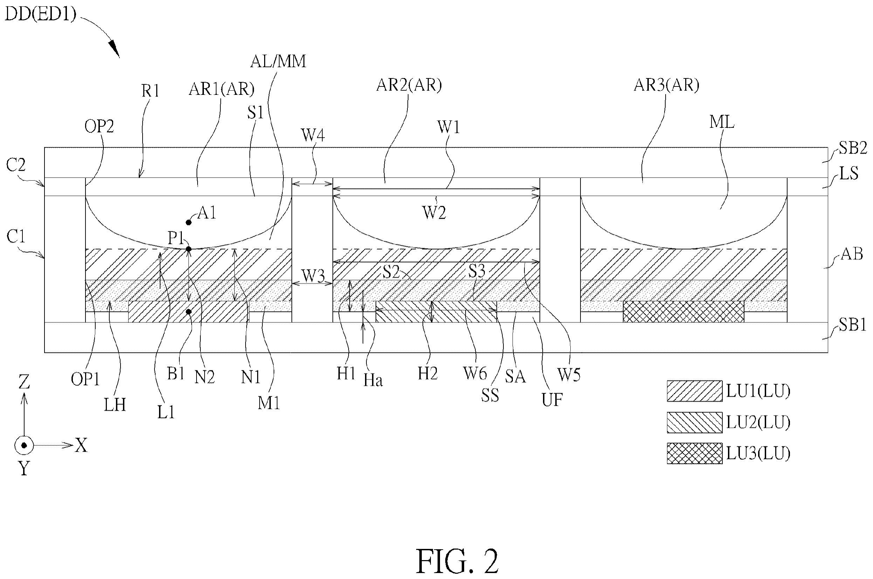

Referring to FIG. 2, FIG. 2 schematically illustrates a cross-sectional view of an electronic device according to a variant embodiment of the first embodiment of the present disclosure. One of the differences between the electronic device ED1 of the present variant embodiment and the electronic device ED shown in FIG. 1 is the design of the first material layer M1. Specifically, in the present embodiment, the first material layer M1 disposed in the opening OP1 may cover the light emitting unit LU, or in other words, the first material layer M1 may cover the top surface S3 of the light emitting unit LU. In such condition, the top surface S2 of the first material layer M1 may be higher than the top surface S3 of the light emitting unit LU. In other words, the sum of the height H1 of the first material layer M1 and the height Ha of the underfill layer UF may be greater than the height H2 of the light emitting unit LU. In the present embodiment, the height Ha of the underfill layer UF may be less than or equal to the height H2 of the light emitting unit LU, and the height H1 of the first material layer M1 may be greater than, equal to or less than the height H2 of the light emitting unit LU, but not limited thereto. In some embodiments, the top surface SA of the underfill layer UF may substantially be aligned with the top surface S3 of the light emitting unit LU, and the top surface S2 of the first material layer M1 may be located above the top surface S3 of the light emitting unit LU. In some embodiments, the underfill layer UF may cover a portion of the side surface SS of the light emitting unit LU, and the first material layer M1 may cover another portion of the side surface SS and the top surface S3 of the light emitting unit LU. In addition, the light channel LH defined by the opening OP1 and located between the light emitting unit LU and the microlens ML may include a portion of the first material layer M1. It should be noted that although it is not shown in FIG. 2, the electronic device ED1 may further include the above-mentioned material layer MM disposed on the first material layer M1, but not limited thereto. The structural features of other layers or elements in the electronic device ED1 may refer to the structural description of the electronic device ED mentioned above, and will not be redundantly described.

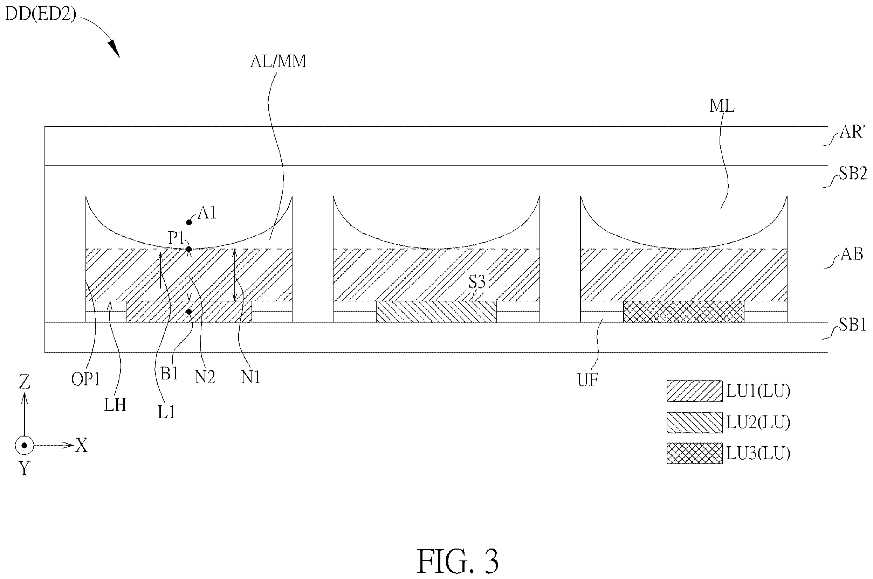

Referring to FIG. 3, FIG. 3 schematically illustrates a cross-sectional view of an electronic device according to a variant embodiment of the first embodiment of the present disclosure. Compared with the electronic device ED shown in FIG. 1, the electronic device ED2 of the present variant embodiment may not include the light shielding layer LS and the anti-reflection layer AR. In such condition, the light absorbing layer AB may directly contact the second substrate SB2, but not limited thereto. For example, the light absorbing layer AB may be sandwiched between the first substrate SB1 and the second substrate SB2. In addition, the microlens ML may directly contact the second substrate SB2, but not limited thereto. Specifically, after providing the second substrate SB2, the microlenses ML may be directly disposed on the second substrate SB2. In some embodiments, the light absorbing layer AB may be disposed on the first substrate SB1 at first, and then the first substrate SB1 and the second substrate SB2 are combined to form the electronic device ED2. In some embodiments, the light absorbing layer AB may be disposed on the second substrate SB2 at first, and then the first substrate SB1 and the second substrate SB2 are combined to form the electronic device ED2. As shown in FIG. 3, the air layer AL, the light emitting unit LU and the underfill layer UF may be included between the microlens ML and the first substrate SB1 in the electronic device ED2, but not limited thereto. In other embodiments, the electronic device ED2 may further include the above-mentioned first material layer M1 and/or the material layer MM disposed on the first material layer M1. In addition, the electronic device ED2 may further include an anti-reflection layer AR' disposed on the second substrate SB2. Specifically, the anti-reflection layer AR' is disposed at a side of the second substrate SB2 opposite to the microlens ML. The anti-reflection layer AR' may directly contact the second substrate SB2, but not limited thereto. The anti-reflection layer AR' may for example include a circular polarizing filter (CPL) or other suitable anti-reflection elements. Through the disposition of the anti-reflection layer AR', the possibility that external light (such as ambient light) is reflected by the elements in the electronic device ED2 and then be observed by the user may be reduced, thereby improving the light emitting effect of the electronic device ED2. For example, the ambient contrast ratio may be increased.

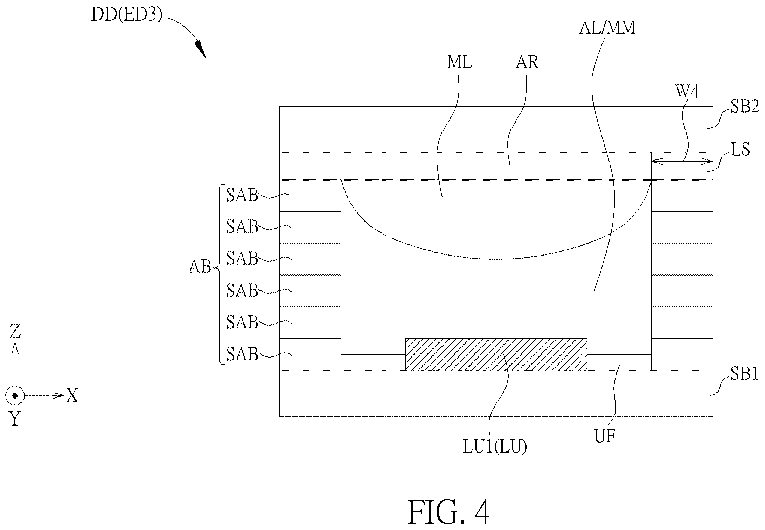

Referring to FIG. 4, FIG. 4 schematically illustrates a cross-sectional view of an electronic device according to a variant embodiment of the first embodiment of the present disclosure. One of the differences between the electronic device ED3 of the present variant embodiment and the electronic device ED shown in FIG. 1 is the structural design of the light absorbing layer AB. According to the present variant embodiment, the light absorbing layer AB may include a multi-layer structure formed by stacking a plurality of sub light absorbing layers SAB. Specifically, the electronic device ED3 may include a plurality of sub light absorbing layers SAB, wherein these sub light absorbing layers SAB may be stacked along the normal direction of the electronic device ED3, thereby forming the light absorbing layer AB. In some embodiments, the sub light absorbing layers SAB may be stacked on the first substrate SB1 to form the light absorbing layer AB at first, and then the first substrate SB1 and the second substrate SB2 are combined to form the electronic device ED3. In some embodiments, the sub light absorbing layers SAB may be stacked on the second substrate SB2 to form the light absorbing layer AB at first, and then the first substrate SB1 and the second substrate SB2 are combined to form the electronic device ED3. In some embodiments, a portion of the sub light absorbing layers SAB may be stacked on the first substrate SB1, and another portion of the sub light absorbing layers SAB may be stacked on the second substrate SB2 at first, and then the first substrate SB1 and the second substrate SB2 are combined to form the electronic device ED3, wherein the portion of the sub light absorbing layers SAB on the first substrate SB1 may correspond to the another portion of the sub light absorbing layers SAB on the second substrate SB2, thereby forming the light absorbing layer AB. In the present variant embodiment, the material of the sub light absorbing layer SAB may be disposed at a predetermined disposition position of the light absorbing layer AB on the substrate (such as the first substrate SB1 and/or the second substrate SB2) for example by yellow light development, spraying and curing or other suitable processes to form the sub light absorbing layer SAB. It should be noted that the light absorbing layers AB in the embodiments and variant embodiments of the present disclosure may also be formed through the process mentioned above, but not limited thereto. The material of the sub light absorbing layer SAB may refer to the material of the light absorbing layer AB mentioned above, but not limited thereto. In some embodiments, the sub light absorbing layer SAB may include a solid structure. In some embodiments, the sub light absorbing layer SAB may include a hollow structure, such as a hollow columnar structure. In some embodiments, the sub light absorbing layer SAB may be formed by arranging and/or stacking light absorbing materials at a high density. For example, the sub light absorbing layer SAB may be formed by arranging and/or stacking photo spacers at a high density, but not limited thereto. It should be noted that the materials, structures or disposition ways of different sub light absorbing layers SAB may be the same or different. According to the present variant embodiment, in a cross-sectional view of the electronic device ED3, the widths of the sub light absorbing layers SAB may be less than or equal to the width (such as the width W4 mentioned above) of the light shielding layer LS. Specifically, in some embodiments, the sub light absorbing layers SAB may have the same width which is less than or equal to the width W4 of the light shielding layer LS. In some embodiments, the widths of the sub light absorbing layers SAB may be different, and the widths of the sub light absorbing layers SAB may respectively be less than or equal to the width W4 of the light shielding layer LS. In some embodiments, the light shielding layer LS and the light absorbing layer AB may be formed in the same process. For example, the light absorbing materials may be stacked on the first substrate SB1 or the second substrate SB2 through the above-mentioned process to form the light shielding layer LS and the light absorbing layer AB. It should be noted that although FIG. 4 just shows the light emitting units LU and the underfill layer UF surrounding the light emitting units LU, the electronic device ED3 may further include the above-mentioned first material layer M1 and/or the material layer MM disposed on the first material layer M1. The structural features of other layers or elements in the electronic device ED3 may refer to the structural description of the electronic device ED mentioned above, and will not be redundantly described.

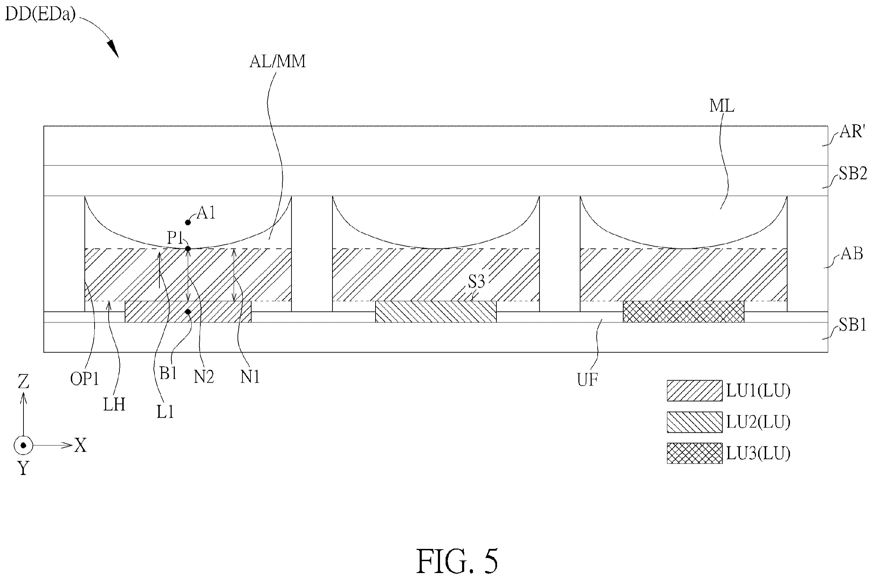

Referring to FIG. 5, FIG. 5 schematically illustrates a cross-sectional view of an electronic device according to a variant embodiment of the first embodiment of the present disclosure. In the present variant embodiment, the light absorbing layer AB of the electronic device EDa may be disposed on the underfill layer UF. Specifically, in the manufacturing process of the electronic device EDa, the light emitting units LU may be disposed on the first substrate SB1 at first, and then the underfill layer UF may be disposed, wherein the underfill layer UF may be a continuous layer and surround the plurality of light emitting units LU at the same time. After that, the light absorbing layer AB may be disposed on the underfill layer UF. In such condition, the light absorbing layer AB may not contact the first substrate SB1, or the underfill layer UF may at least partially be disposed between the light absorbing layer AB and the first substrate SB1 in the normal direction (that is, the direction Z) of the electronic device EDa. In addition, the underfill layer UF may not be disposed in the opening OP1. As shown in FIG. 5, when the underfill layer UF does not completely cover the side surface SS of the light emitting unit LU, the light emitting unit LU may be partially disposed in the opening OP1 of the light absorbing layer AB. When the underfill layer UF completely cover the side surface SS of the light emitting unit LU, the light emitting unit LU may be disposed corresponding to the opening OP1 but not disposed in the opening OP1. It should be noted that although it is not shown in FIG. 5, the electronic device EDa may further include the above-mentioned first material layer M1 and/or the material layer MM disposed on the first material layer M1. In some embodiments, the first material layer M1 may be disposed in the opening OP1 of the light absorbing layer AB. In some embodiments, the first material layer M1 may be a continuous layer disposed on the underfill layer UF, and the light absorbing layer AB may be disposed on the first material layer M1. That is, the first material layer M1 may be partially disposed between the light absorbing layer AB and the first substrate SB1 in the normal direction of the electronic device EDa. The structural features of the layers or elements in the electronic device EDa may refer to the structural description of the electronic device ED mentioned above, and will not be redundantly described.

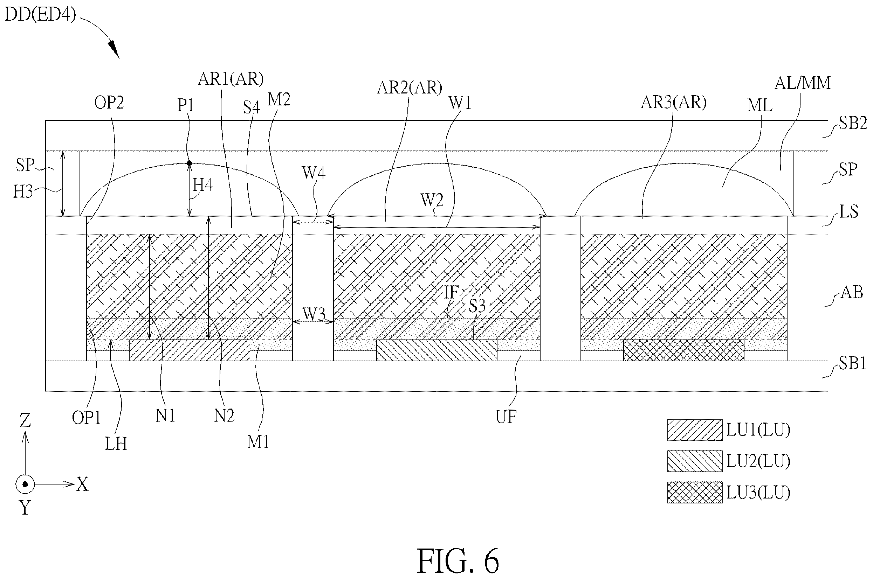

Referring to FIG. 6, FIG. 6 schematically illustrates a cross-sectional view of an electronic device according to a second embodiment of the present disclosure. According to the present embodiment, the microlens ML of the electronic device ED4 may be located at a side of the anti-reflection layer AR away from the light emitting unit LU. In other words, the microlens ML may be located on the anti-reflection layer AR, or the microlens ML may be located between the anti-reflection layer AR and the second substrate SB2. In detail, as shown in FIG. 6, the electronic device ED4 may include a plurality of microlenses ML respectively corresponding to one of the light emitting units LU, and these microlenses ML may respectively be located on one of the anti-reflection layers AR. The disposition position of the microlens ML may be designed, such that the center of the microlens ML may overlap the center of the light emitting layer (not shown) of the light emitting unit LU (the details may refer to the contents mentioned above, and will not be redundantly described). The microlens ML may cover the top surface (that is, the surface S4) or the surface away from the light emitting unit LU of the anti-reflection layer AR to which the microlens ML corresponds. For example, in the present embodiment, two ends of the microlens ML may respectively extend beyond two ends of the anti-reflection layer AR to which the microlens ML corresponds, but not limited thereto. In such condition, in the normal direction of the electronic device ED4 , the microlens ML may at least partially overlap the light shielding layer LS and at least partially overlap the light absorbing layer AB. In some embodiments, two ends of the microlens ML may respectively be aligned with two ends of the anti-reflection layer AR. In other words, in a cross-sectional view of the electronic device ED4, the width W1 of the anti-reflection layer AR may be less than or equal to the width W2 of the microlens ML to which the anti-reflection layer AR corresponds. Through the above-mentioned design, the disposition range of the anti-reflection layer AR may fall within the disposition range of the microlens ML to which the anti-reflection layer AR corresponds. In addition, in the present embodiment, the width W3 of the light absorbing layer AB may be less than or equal to the width W4 of the light shielding layer LS, wherein the details thereof may refer to the contents mentioned above and will not be redundantly described.

According to the present embodiment, the electronic device ED4 may further include a supporting element SP located between the second substrate SB2 and the light shielding layer LS. Specifically, the supporting element SP may be disposed corresponding to the light shielding layer LS and may provide support to the second substrate SB2. The supporting element SP may include photo spacer or other suitable supporting materials. It should be noted that the disposition position of the supporting element SP is not limited to what is shown in FIG. 6. In the present embodiment, the supporting element SP may have a height H3, and the microlens ML may have a height H4, wherein the height H3 may be greater than the height H4, but not limited thereto. In such condition, the microlens ML may not contact the second substrate SB2. In some embodiments, the height H3 of the supporting element SP may be the same as the height H4 of the microlens ML. In such condition, the microlens ML may contact the second substrate SB2, for example, the highest point (such as the point P1 mentioned above) of the microlens ML may contact the second substrate SB2. In the normal direction of the electronic device ED4, the height H3 may for example be defined as the maximum height of the supporting element SP, and the height H4 may for example be defined as the maximum height of the microlens ML. In addition, the electronic device ED4 may include the air layer AL located between the microlens ML and the second substrate SB2, but not limited thereto. In some embodiments, the air layer AL of the electronic device ED4 may be replaced by other material layers. Specifically, the electronic device ED4 may further include a material layer MM disposed between the second substrate SB2 and the microlens ML. In such condition, the material layer MM may include a glue material or a photoresist material having a refractive index greater than or equal to 1.0 and less than or equal to the refractive index of the microlens ML.

According to the present embodiment, the electronic device ED4 may further include the underfill layer UF, the first material layer M1 and the second material layer M2, wherein the underfill layer UF is disposed on the first substrate SB1, the first material layer M1 is disposed on the underfill layer UF, and the second material layer M2 is disposed on the first material layer M1. The underfill layer UF may surround the light emitting unit LU to fix the light emitting unit LU on the first substrate SB1, wherein the details thereof may refer to the contents mentioned above and will not be redundantly described. The first material layer M1 and the second material layer M2 may include glue materials (such as optical clear adhesive (OCA), but not limited thereto), photoresist materials or other suitable materials. The refractive index of the first material layer M1 and the refractive index of the second material layer M2 may be greater than 1.0 and less than or equal to 1.8, but not limited thereto. In addition, the refractive index of the first material layer M1 may be less than or equal to the refractive index of the second material layer M2. In other words, the glue material or the photoresist material having a refractive index greater than 1.0 and less than or equal to 1.8 may serve as the material of the first material layer M1, and the glue material or the photoresist material having a refractive index greater than or equal to the refractive index of the first material layer M1 and greater than 1.0 and less than or equal to 1.8 may serve as the material of the second material layer M2. In the present embodiment, an interface IF between the first material layer M1 and the second material layer M2 may be higher than the top surface S3 of the light emitting unit LU, that is, the first material layer M1 may cover the light emitting unit LU, but not limited thereto. In some embodiments, the interface IF between the first material layer M1 and the second material layer M2 may be aligned with the top surface S3 of the light emitting unit LU. In some embodiments, the interface IF between the first material layer M1 and the second material layer M2 may be lower than the top surface S3 of the light emitting unit LU. Although the underfill layer UF, the first material layer M1 and the second material layer M2 may fully fill the opening OP1 of the light absorbing layer AB in FIG. 6, that is, the second material layer M2 may contact the anti-reflection layer AR, it is not limited in the present embodiment. In some embodiments, an air layer may further be included between the second material layer M2 and the anti-reflection layer AR, that is, the second material layer M2 does not contact the anti-reflection layer AR.

In the present embodiment, the electronic device ED4 may for example be formed through the following way. First, the first substrate SB1 may be provided, and the patterned light absorbing layer AB including the plurality of openings OP1 may be disposed on the first substrate SB1. After that, the light emitting units LU, the underfill layer UF, the first material layer M1 and the second material layer M2 may be disposed in the openings OP1. After that, the light shielding layer LS and the anti-reflection layers AR may be disposed on the light absorbing layer AB and the second material layer M2, and the microlenses ML may be disposed on the anti-reflection layers AR. It should be noted that in some embodiments, the light absorbing layer AB and the light shielding layer LS may be formed in the same process, or the light absorbing layer AB and the light shielding layer LS may be one-piece-formed. After that, the supporting element SP may be disposed on the light shielding layer LS, and the second substrate SB2 may be disposed on the supporting element SP, thereby forming the electronic device ED4. In some embodiments, the second substrate SB2 may be provided at first, and then the supporting element SP may be disposed on the second substrate SB2. After that, the second substrate SB2 and the first substrate SB1 may be combined to form the electronic device ED4. It should be noted that the forming method of the electronic device ED4 of the present embodiment is not limited to the method mentioned above.

According to the present embodiment, as mentioned above, the electronic device ED4 may include the light channel LH defined by the light absorbing layer AB and located between the light emitting unit LU and the microlens ML. Specifically, as shown in FIG. 6, the portion of the region surrounded by the light absorbing layer AB (that is, the region of the opening OP1) located between the light emitting unit LU and the microlens ML may be defined as the region of the light channel LH. According to the present embodiment, in an opening OP1, the light channel LH may have a length N1 in the normal direction of the electronic device ED4, and a distance N2 may be included between the light emitting unit LU and the microlens ML corresponding to the light emitting unit LU in the normal direction of the electronic device ED4, wherein the length N1 may be greater than or equal to 60% of the distance N2 (that is, N1≥0.6N2), but not limited thereto. For example, in the present embodiment, the length N1 may be less than the distance N2 and greater than or equal to 60% of the distance N2 (that is, 0.6N2≤N1<N2). The length N1 may be defined as the maximum length of the light channel LH in the normal direction of the electronic device ED4. The distance N2 may be defined as the minimum distance between the light emitting unit LU and the microlens ML in the normal direction of the electronic device ED4, such as the distance between the bottom surface (or the surface in contact with the anti-reflection layer AR) of the microlens ML and the top surface S3 of the light emitting unit LU. The relationship between the length N1 and the distance N2 mentioned above may for example be achieved through the height designs of the anti-reflection layer AR, the light shielding layer LS and/or the light absorbing layer AB, but not limited thereto. The structural features of other layers or elements in the electronic device ED4 may refer to the structural description of the electronic device ED mentioned above, and will not be redundantly described.

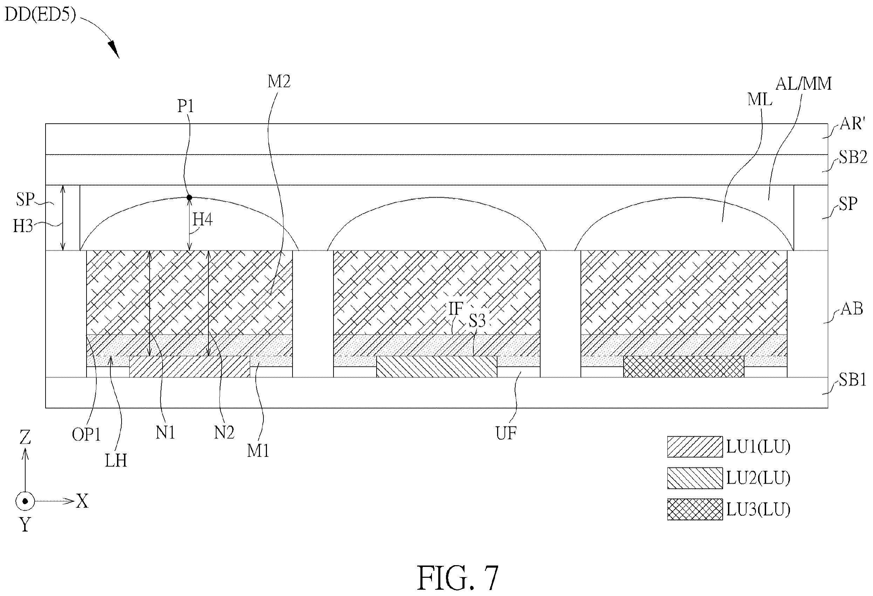

Referring to FIG. 7, FIG. 7 schematically illustrates a cross-sectional view of an electronic device according to a variant embodiment of the second embodiment of the present disclosure. According to the present variant embodiment, the electronic device ED5 may not include the light shielding layer LS and the anti-reflection layer AR. In such condition, the microlenses ML may directly be disposed on the second material layer M2 and contact the second material layer M2 and/or the light absorbing layer AB. For example, in some embodiments, two ends of the microlens ML may respectively extend beyond two ends of the second material layer M2 and partially overlap the light absorbing layer AB. In such condition, the microlens ML may contact the second material layer M2 and the light absorbing layer AB. In some embodiments, two ends of the microlens ML may respectively be aligned with two ends of the second material layer M2. In such condition, the microlens ML may contact the second material layer M2 but not contact the light absorbing layer AB. In the present embodiment, the length N1 of the light channel LH may be the same as the distance N2 between the light emitting unit LU and the microlens ML, but not limited thereto. In some embodiments, other suitable layers may be included between the microlens ML and the second material layer M2, and the length N1 may be less than the distance N2 and greater than or equal to 60% of the distance N2. The structural features of other layers or elements in the electronic device ED5 may refer to the structural description of the electronic device ED4 mentioned above, and will not be redundantly described.

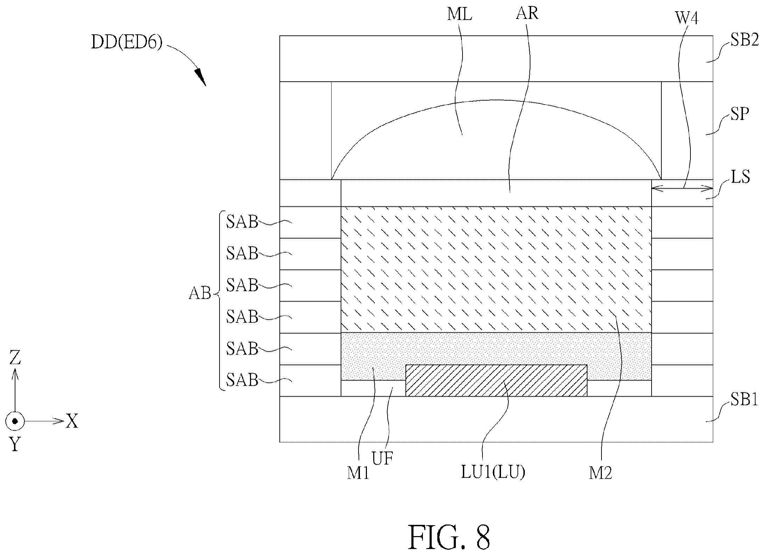

Referring to FIG. 8, FIG. 8 schematically illustrates a cross-sectional view of an electronic device according to a variant embodiment of the second embodiment of the present disclosure. According to the present variant embodiment, the light absorbing layer AB of the electronic device ED6 may include a multi-layer structure formed by stacking a plurality of sub light absorbing layers SAB. The material, the structure and the size of the sub light absorbing layer SAB may refer to FIG. 4 and related description above, and will not be redundantly described. In the present variant embodiment, the material of the sub light absorbing layer SAB may be disposed at a predetermined disposition position of the light absorbing layer AB on the first substrate SB1 for example by yellow light development, spraying and curing or other suitable processes to form the sub light absorbing layer SAB, but not limited thereto. The structural features of other layers or elements in the electronic device ED6 may refer to the structural description of the electronic device ED4 mentioned above, and will not be redundantly described.

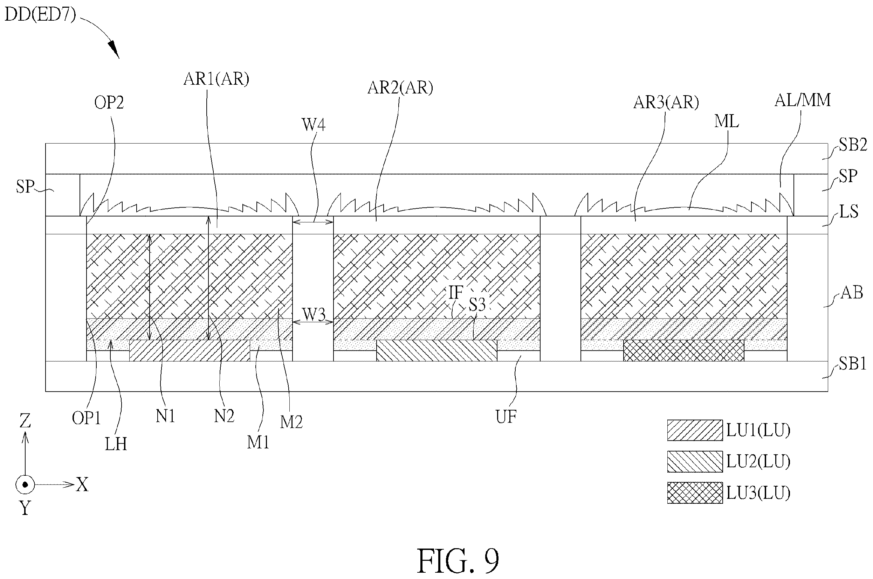

Referring to FIG. 9, FIG. 9 schematically illustrates a cross-sectional view of an electronic device according to a variant embodiment of the second embodiment of the present disclosure. In the present variant embodiment, the microlens ML of the electronic device ED7 may include Fresnel lens, or Fresnel lens may be used instead of the microlens ML. By making the electronic device ED7 include Fresnel lens, the thickness (or height) of the microlens ML may be reduced, thereby reducing the entire thickness of the electronic device ED7. In addition, with the same curvature, since the Fresnel lens may have a shorter focal length than a general lens, the distance between the microlens ML and the light emitting unit LU may be reduced. For example, the distance N2 between the microlens ML and the light emitting unit LU in the electronic device ED7 may be less than the distance N2 between the microlens ML and the light emitting unit LU in the electronic device ED4 mentioned above. In other words, the height of the light absorbing layer AB in the electronic device ED7 may be less than the height of the light absorbing layer AB in the electronic device ED4. Therefore, the entire thickness of the electronic device ED7 may be further reduced.

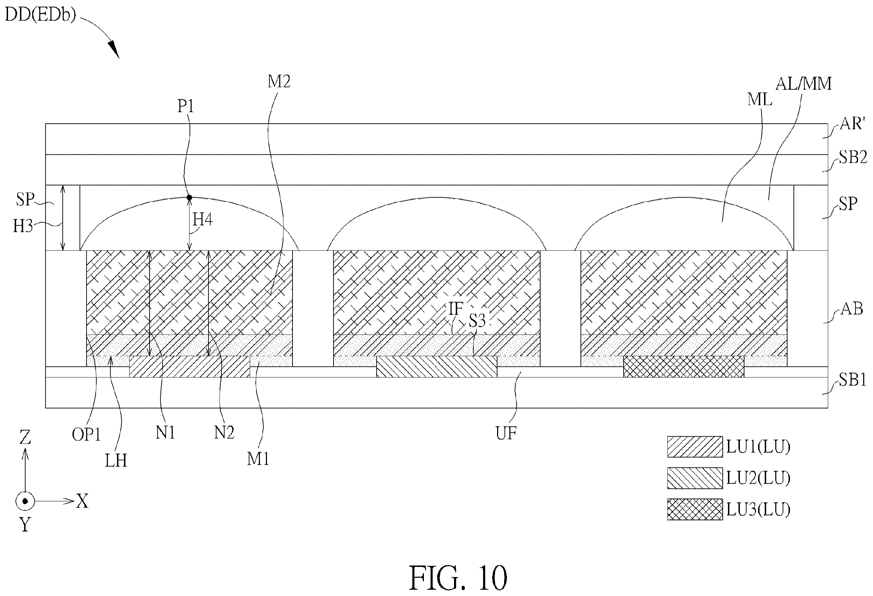

Referring to FIG. 10, FIG. 10 schematically illustrates a cross-sectional view of an electronic device according to a variant embodiment of the second embodiment of the present disclosure. In the present variant embodiment, the light absorbing layer AB of the electronic device EDb may be disposed on the underfill layer UF. Specifically, in the manufacturing process of the electronic device EDb, the light emitting units LU may be disposed on the first substrate SB1 at first, and then the underfill layer UF may be disposed, wherein the underfill layer UF may be a continuous layer and surround the plurality of light emitting units LU at the same time. After that, the light absorbing layer AB may be disposed on the underfill layer UF, and the first material layer M1 and the second material layer M2 may be disposed in the openings OP1 of the light absorbing layer AB. In such condition, the underfill layer UF may be partially disposed between the light absorbing layer AB and the first substrate SB1 in the normal direction of the electronic device EDb. In addition, the underfill layer UF is not disposed in the opening OP1. In some embodiments, the first material layer M1 may be a continuous layer disposed on the underfill layer UF, and the light absorbing layer AB may be disposed on the first material layer M1. In such condition, the first material layer M1 may not be disposed in the opening OP1.

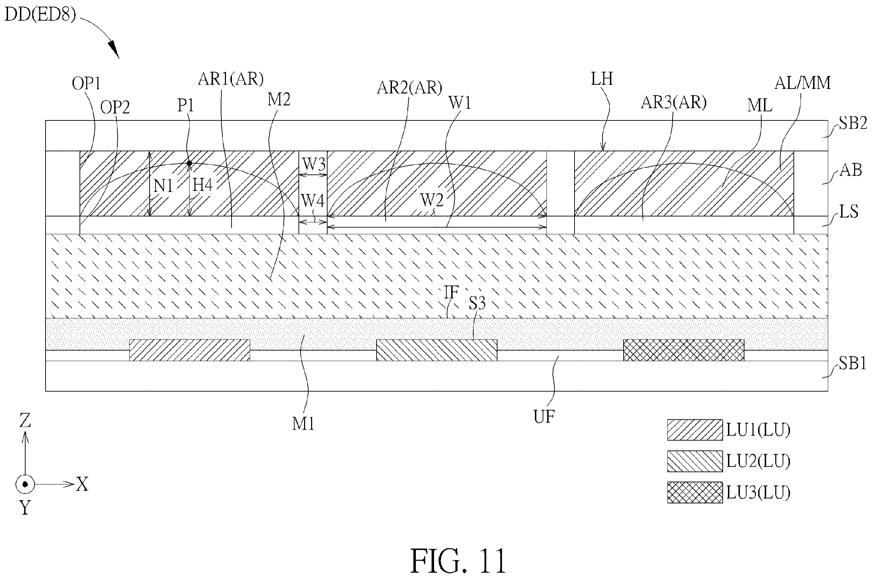

Referring to FIG. 11, FIG. 11 schematically illustrates a cross-sectional view of an electronic device according to a third embodiment of the present disclosure. According to the present embodiment, the electronic device ED8 may include the first substrate SB1, the light emitting units LU located on the first substrate SB1, the underfill layer UF located on the first substrate SB1, the first material layer M1 located on the underfill layer UF and the second material layer M2 located on the first material layer M1. As shown in FIG. 11, the underfill layer UF may be comprehensively disposed on the first substrate SB1 and surround the light emitting units LU. The first material layer M1 may be comprehensively disposed on the underfill layer UF and cover the light emitting units LU disposed on the first substrate SB1 at the same time, and the second material layer M2 may be comprehensively disposed on the first material layer M1, but not limited thereto. In other words, compared with the electronic device ED4 shown in FIG. 6 , the first material layer M1 and the second material layer M2 of the electronic device ED8 of the present embodiment may be continuous and not disposed in the opening OP1 of the light absorbing layer AB. It should be noted that in some embodiments, the interface IF between the first material layer M1 and the second material layer M2 may be aligned with or lower than the top surface S3 of the light emitting unit LU, which is not limited to what is shown in FIG. 11. The refractive index of the first material layer M1 is less than or equal to the refractive index of the second material layer M2. The material selections and the ranges of the refractive index of the first material layer M1 and the second material layer M2 may refer to FIG. 6 and the related contents mentioned above, and will not be redundantly described. The electronic device ED8 may further include the light shielding layer LS and the anti-reflection layers AR located on the first substrate SB1. For example, the light shielding layer LS may be directly disposed on the second material layer M2 and include the plurality of openings OP2, and the anti-reflection layers AR may be disposed corresponding to the light emitting units LU in the openings OP2 and contact the second material layer M2, but not limited thereto. In some embodiments, other layers may be included between the second material layer M2 and the light shielding layer LS (or the anti-reflection layer AR). The electronic device ED8 may further include the light absorbing layer AB and the microlenses ML located on the first substrate SB1. The light absorbing layer AB may be disposed corresponding to the light shielding layer LS and include the plurality of openings OP1, wherein these openings OP1 respectively correspond to one of the light emitting units LU. The microlenses ML may be respectively disposed in one of the openings OP1 and correspond to the light emitting units LU. Two ends of the microlens ML may contact the light absorbing layer AB, but not limited thereto. The center of the microlens ML may overlap the center of the light emitting layer of the light emitting unit LU to which the microlens ML corresponds, and the details thereof may refer to the contents mentioned above, which will not be redundantly described. In a cross-sectional view of the electronic device ED8, the width of the anti-reflection layer AR (such as the width W1) may be less than or equal to the width (such as the width W2) of the microlens ML to which the anti-reflection layer AR corresponds, and the width W3 of the light absorbing layer AB may be less than or equal to the width W4 of the light shielding layer LS. When the width W1 of the anti-reflection layer AR is less than the width W2 of the microlens ML, the microlens ML may partially overlap the light shielding layer LS. In the present embodiment, the light absorbing layer AB may directly contact the light shielding layer LS, and the microlenses ML may be disposed on the anti-reflection layers AR and directly contact the anti-reflection layers AR, but not limited thereto. The electronic device ED8 may further include the second substrate SB2 located on the light absorbing layer AB. The air layer AL may be included between the second substrate SB2 and the microlens ML, wherein the air layer AL may correspond to the opening OP1, but not limited thereto. In some embodiments, the air layer AL may be replaced by other material layers. For example, the electronic device ED8 may include the material layer MM located between the second substrate SB2 and the microlens ML. The material layer MM may include the glue material or the photoresist material having a refractive index greater than or equal to 1.0 and less than or equal to the refractive index of the microlens ML. It should be noted that the structure of the electronic device ED8 is not limited to what is shown in FIG. 11 and may further include other elements or layers.

In the present embodiment, the electronic device ED8 may be formed through the following way. Specifically, the first substrate SB1 may be provided at first, and then the light emitting units LU, the underfill layer UF, the first material layer M1 and the second material layer M2 may be sequentially disposed on the first substrate SB1. After that, the light shielding layer LS and the anti-reflection layers AR may be disposed on the second material layer M2, the light absorbing layer AB may be disposed on the light shielding layer LS, and the microlenses ML may be disposed on the anti-reflection layers AR. After that, the second substrate SB2 may be disposed on the light absorbing layer AB to form the electronic device ED8. It should be noted that in some embodiments, the light absorbing layer AB may be disposed on the second substrate SB2, and then the first substrate SB1 and the second substrate SB2 are combined to form the electronic device ED8.

According to the present embodiment, the light absorbing layer AB may define the light channel LH, and the microlens ML may be disposed in the light channel LH. Specifically, the region of the light channel LH may be defined as the region surrounded by the light absorbing layer AB, that is, the region of the opening OP1. In the present embodiment, the region of an opening OP1 may be regarded as the region of a light channel LH, wherein the light channel LH may correspond to the light emitting unit LU (for example, correspond to one light emitting unit LU, but not limited thereto), and the microlens ML (for example, one microlens ML, but not limited thereto) may be disposed in the light channel LH. According to the present embodiment, in an opening OP1, the light channel LH may have a length N1 in the normal direction of the electronic device ED8, and the microlens ML disposed in the opening OP1 may have a height (such as the height H4), wherein the length N1 may be greater than or equal to the height H4 of the microlens ML. In some embodiments, the length N1 may be greater than the height H4, and the microlens ML may not contact the second substrate SB2. In some embodiments, the length N1 may be the same as the height H4, and the microlens ML may contact the second substrate SB2. For example, the highest point (the point P1) of the microlens ML may contact the second substrate SB2.

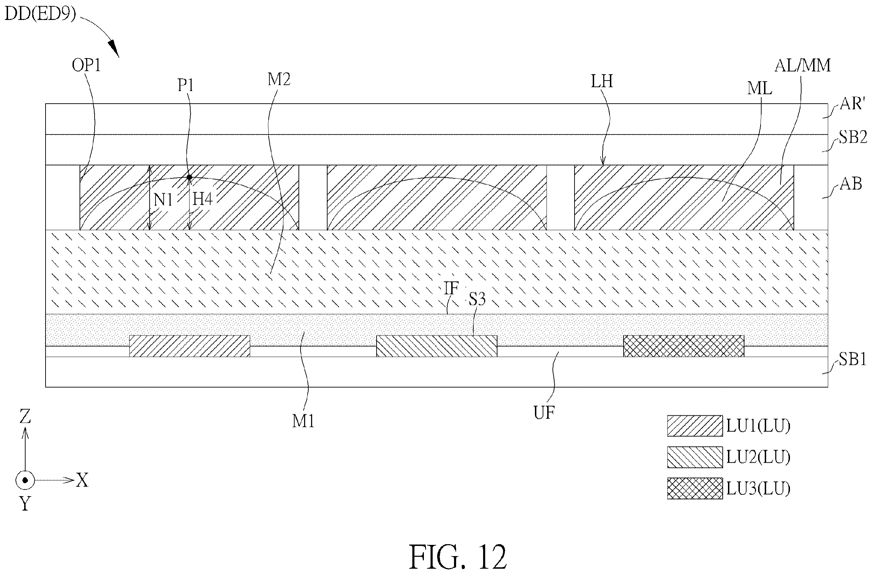

Referring to FIG. 12, FIG. 12 schematically illustrates a cross-sectional view of an electronic device according to a variant embodiment of the third embodiment of the present disclosure. Compared with the electronic device ED8 shown in FIG. 11, the electronic device ED9 of the present variant embodiment may not include the light shielding layer LS and the anti-reflection layer AR. In such condition, the microlenses ML and the light absorbing layer AB may be directly disposed on the second material layer M2 and may contact the second material layer M2. In addition, in the present variant embodiment, the electronic device ED9 may further include the anti-reflection layer AR' disposed on the second substrate SB2 or disposed at a side of the second substrate SB2 opposite to the microlens ML. The feature of the anti-reflection layer AR' may refer to the contents mentioned above, and will not be redundantly described.

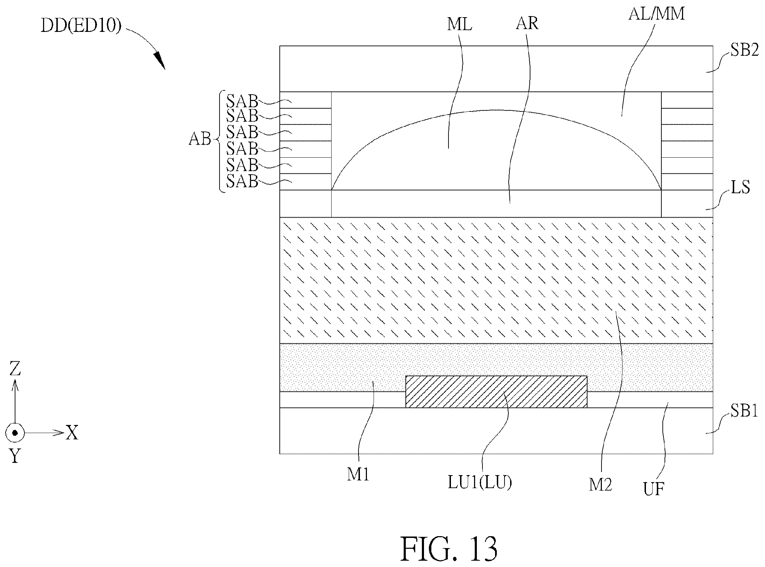

Referring to FIG. 13, FIG. 13 schematically illustrates a cross-sectional view of an electronic device according to a variant embodiment of the third embodiment of the present disclosure. According to the present variant embodiment, the light absorbing layer AB may include a multi-layer structure formed by stacking a plurality of sub light absorbing layers SAB along the normal direction of the electronic device ED10. In some embodiments, the sub light absorbing layers SAB may be stacked on the first substrate SB1 to form the light absorbing layer AB at first, and then the first substrate SB1 and the second substrate SB2 are combined to form the electronic device ED10. In some embodiments, the sub light absorbing layers SAB may be stacked on the second substrate SB2 to form the light absorbing layer AB at first, and then the first substrate SB1 and the second substrate SB2 are combined to form the electronic device ED10. In some embodiments, a portion of the sub light absorbing layers SAB may be stacked on the first substrate SB1, and another portion of the sub light absorbing layers SAB may be stacked on the second substrate SB2 at first, and then the first substrate SB1 and the second substrate SB2 are combined to form the electronic device ED10. The material, the structure and the size of the sub light absorbing layer SAB may refer to FIG. 4 and related description above, and will not be redundantly described. The material of the sub light absorbing layer SAB may be disposed at a predetermined disposition position of the light absorbing layer AB on the substrate (such as the first substrate SB1 and/or the second substrate SB2) for example by yellow light development, spraying and curing or other suitable processes to form the sub light absorbing layer SAB, but not limited thereto.

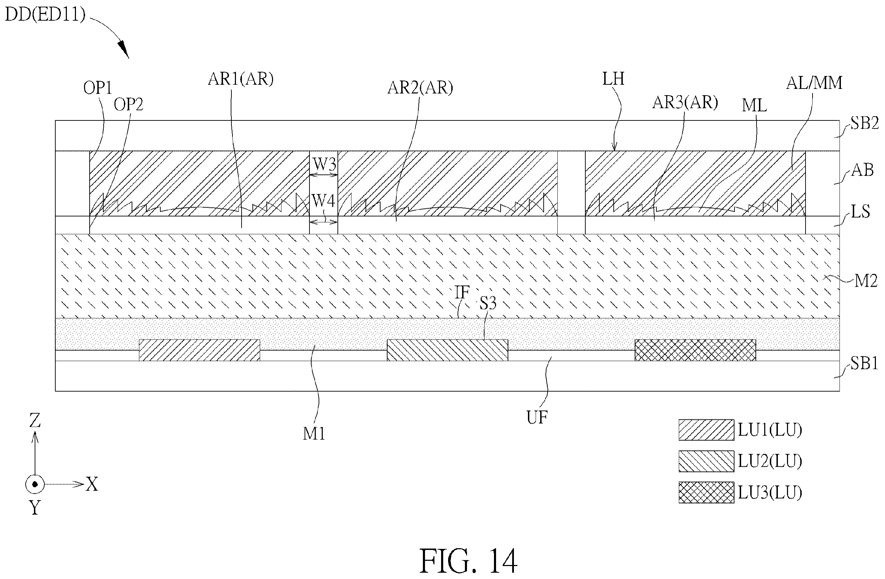

Referring to FIG. 14, FIG. 14 schematically illustrates a cross-sectional view of an electronic device according to a variant embodiment of the third embodiment of the present disclosure. In the present variant embodiment, the electronic device ED11 may include Fresnel lens, or Fresnel lens may be used instead of the microlens ML. By making the electronic device ED11 include Fresnel lens, the entire thickness of the electronic device ED11 may be reduced.

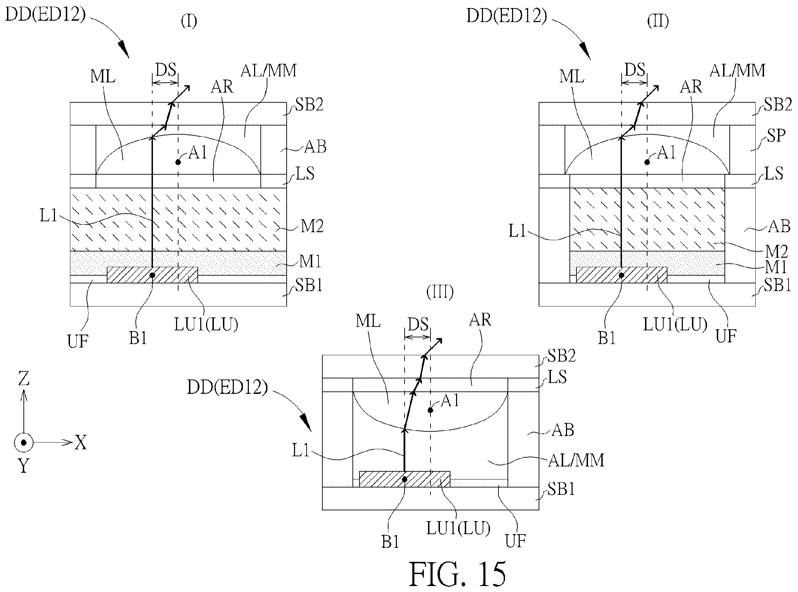

Referring to FIG. 15, FIG. 15 schematically illustrates a cross-sectional view of an electronic device according to a fourth embodiment of the present disclosure. According to the present embodiment, in a cross-sectional view of the electronic device ED12, the center (that is, the point B1) of the light emitting region of the light emitting unit LU may deviate from the center (that is, the point A1) of the microlens ML to which the light emitting unit LU corresponds. As mentioned above, the center of the light emitting region of the light emitting unit LU may for example be defined as the geometric center of the cross-sectional shape of the light emitting region of the light emitting unit LU, and the center of the microlens ML may for example be defined as the geometric center of the cross-sectional shape of the microlens ML. In some embodiments, "the center of the light emitting region of the light emitting unit LU deviates from the center of the microlens ML to which the light emitting unit LU corresponds" mentioned above may represent that in a top view of the electronic device ED12, the geometric center of the top-view shape of the light emitting region of the light emitting unit LU deviates from the geometric center of the top-view shape of the microlens ML. The electronic device ED12 may be any one of the electronic devices in the above-mentioned embodiments. For example, in FIG. 15, the structure (I) shows the structure that the center of the light emitting region of the light emitting unit LU deviates from the center of the microlens ML in a cross-sectional view of the electronic device ED8; the structure (II) shows the structure that the center of the light emitting region of the light emitting unit LU deviates from the center of the microlens ML in a cross-sectional view of the electronic device ED4; and the structure (III) shows the structure that the center of the light emitting region of the light emitting unit LU deviates from the center of the microlens ML in a cross-sectional view of the electronic device ED. By making the center of the light emitting region of the light emitting unit LU deviate from the center of the microlens ML, the light emitting angle (or the brightness center) of the light L1 emitted by the light emitting unit LU may deviate. In such condition, the maximum brightness of the electronic device ED12 may not correspond to the position of the normal viewing angle (or the viewing angle of 0 degree), that is, the viewing angle corresponding to the maximum brightness of the electronic device ED12 may deviated from the normal viewing angle.

According to the present embodiment, the deviation angle of the viewing angle corresponding to the maximum brightness of the electronic device ED12 deviating from the normal viewing angle may be affected by the width (that is, the width W2 mentioned above) and the height (that is, the height H4 mentioned above) of the microlens ML, the distance between a light emitting unit LU and the microlens ML corresponding to the light emitting unit (that is, the distance N2 mentioned above), and the distance DS between the center of the light emitting region of the light emitting unit LU and the center of the microlens ML. The deviation angle may be defined as the included angle between the viewing angle corresponding to the maximum brightness of the electronic device ED12 and the normal direction of the electronic device ED12. The distance DS may be defined as the distance between the center of the light emitting region of the light emitting unit LU and the center of the microlens ML in the horizontal direction (that is, the direction X) in the cross-sectional view of the electronic device ED12. In other words, the distance DS may be regarded as the deviation distance between the center of the light emitting region of the light emitting unit LU and the center of the microlens ML. In the present embodiment, the width W2 may range from 30µm to 60µm (that is, 30µm≤W2≤60µm), the height H4 may range from 10µm to 30µm (that is, 10µm≤H4≤30µm), and the distance N2 may range from 20µm to 40µm (that is, 20µm≤N2≤40µm), but not limited thereto. It should be noted that the ranges of the width W2, the height H4 and the distance N2 mentioned above may be applied to the electronic devices in the embodiments and variant embodiments of the present disclosure. Under the above-mentioned size design, when the center of the light emitting region of the light emitting unit LU deviates from the center of the microlens ML by 1µm (that is, the distance DS is 1 µm), the deviation angle of the viewing angle corresponding to the maximum brightness of the electronic device ED12 deviating from the normal viewing angle may range from 1 degree to 3.5 degrees (that is., 1°≤deviation angle≤3.5°), but not limited thereto. The following table 1 shows the deviation angle of the viewing angle corresponding to the maximum brightness of the electronic device ED12 deviating from the normal viewing angle when the center of the light emitting region of the light emitting unit LU deviates from the center of the microlens ML by 1 µm (that is, the distance DS) under different widths W2, heights H4 and distances N2. It should be noted that the simulation results presented in table 1 below were obtained using the structure (II) shown in FIG. 15.

**Table 1**

| number | width W2(µm) | height H4(µm) | distance N2(µm) | deviation angle (degree) |
|---|---|---|---|---|
| 1 | 30 | 10 | 40 | 1.5 |
| 2 | 30 | 15 | 40 | 1.3 |
| 3 | 30 | 10 | 20 | 3.3 |
| 4 | 30 | 15 | 20 | 2.8 |
| 5 | 60 | 10 | 40 | 1.8 |
| 6 | 60 | 30 | 40 | 1.5 |
| 7 | 60 | 10 | 20 | 2.0 |
| 8 | 60 | 30 | 20 | 2.3 |

It can be seem from table 1 that by making the center of the light emitting region of the light emitting unit LU deviates from the center of the microlens ML, the viewing angle corresponding to the maximum brightness of the electronic device ED12 may deviate from the normal viewing angle. In addition, when the distance N2 between the light emitting unit LU and the microlens ML is lower, the deviation angle may be greater.

The electronic device ED12 of the present embodiment may serve as a vehicle display, such as a panoramic display (PUHD), but not limited thereto. For example, the electronic device ED12 may be combined with the operating panel, the windshield, the window or other suitable components in a vehicle, but not limited thereto. In such condition, since the surfaces of the components in the above-mentioned vehicle may have different degrees of inclination, the viewing angle corresponding to the maximum brightness of the electronic device ED12 may be adjusted by making the center of the light emitting region of the light emitting unit LU deviate from the center of the microlens ML, thereby improving the user's viewing experience when the electronic device ED12 is placed in different positions. For example, the viewing angle corresponding to the maximum brightness of the electronic device ED12 may be determined according to the disposition position of the electronic device ED12 at first, such that the above-mentioned deviation angle may be confirmed. After that, the parameters such as the width W2, the height H4, the distance N2 and/or the distance DS may be designed according to the demands of the deviation angle. It should be noted that the application of the electronic device ED12 is not limited to the contents mentioned above. The features of other elements or layers of the electronic device ED12 may refer to the contents mentioned above, and will not be redundantly described.

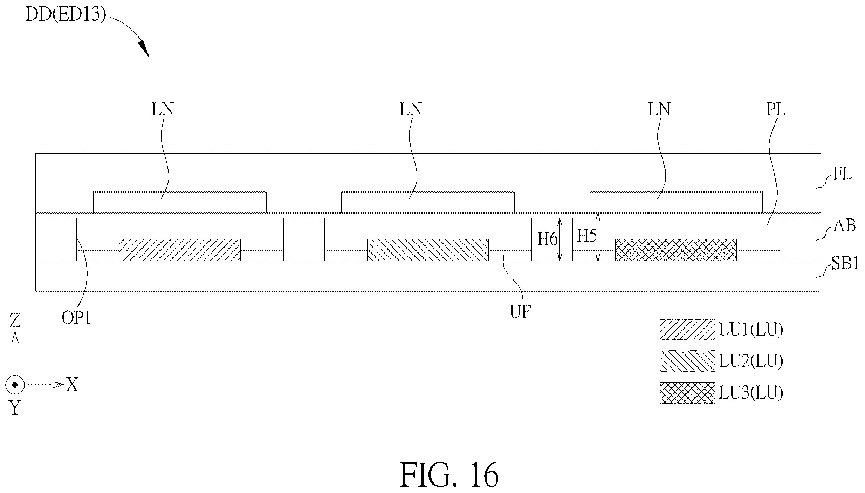

Referring to FIG. 16, FIG. 16 schematically illustrates a cross-sectional view of an electronic device according to a fifth embodiment of the present disclosure. According to the present embodiment, the electronic device ED13 may include metalens, or metalens may be used to replace the microlens ML in the electronic devices mentioned above. Specifically, as shown in FIG. 16, the electronic device ED13 may include the first substrate SB1, and the light emitting units LU, the underfill layer UF and the light absorbing layer AB disposed on the first substrate SB1. The light absorbing layer AB may be directly disposed on the first substrate SB1 and include the plurality of openings OP1, and the light emitting units LU and the underfill layer UF may be disposed in the openings OP1 and contact the first substrate SB1, but not limited thereto. The features of the first substrate SB1, the light emitting units LU, the underfill layer UF and the light absorbing layer AB may refer to the contents mentioned above, and will not be redundantly described. The electronic device ED13 may further include a planarization layer PL disposed on the first substrate SB1. In the present embodiment, a distance H5 between the top surface of the planarization layer PL and the top surface of the first substrate SB1 may be greater than a height H6 of the light absorbing layer AB, but not limited thereto. In such condition, the planarization layer PL may fill into the openings OP1 and cover the light absorbing layer AB, the underfill layer UF and the light emitting units LU. In some embodiments, the distance H5 may be less than or equal to the height H6 of the light absorbing layer AB. In such condition, the planarization layer PL may be disposed corresponding to the openings OP1 and cover the light emitting units LU and the underfill layer UF, but the planarization layer PL does not cover the light absorbing layer AB. In other words, the planarization layer PL may have a discontinuous structure. The planarization layer PL may include any suitable photoresist material. The planarization layer PL may provide a flat top surface to facilitate disposition of lens units LN thereon. The lens units LN may be directly disposed on the planarization layer PL, but not limited thereto. The lens units LN may respectively be disposed corresponding to one of the light emitting units LU. In the present embodiment, the lens unit LN may include metalens. The metalens may for example be formed by periodically arranging nano-sized columnar elements, wherein the columnar elements may have characteristics of lens after being arranged and may for example be used to concentrate light. The metalens may for example be formed through deep ultraviolet lithography, nanoimprint lithography or other suitable processes. In such condition, a lens unit LN may be used to concentrate the light emitted by the light emitting unit LU to which the lens unit LN corresponds. Therefore, the electronic device ED13 may have a narrow viewing angle. The material of the above-mentioned columnar elements may include titanium dioxide (TiO₂), gallium nitride (GaN), silicon nitride (Si₃N₄), and the like, but not limited thereto. The electronic device ED13 may further include a functional layer FL disposed on the lens units LN, wherein the functional layer FL may include one or more of the layers such as an adhesive layer, a protecting layer, an anti-fouling layer and the second substrate SB2, the anti-reflection layer AR' and the air layer AL mentioned above, based on the demands of design of the electronic device ED13.

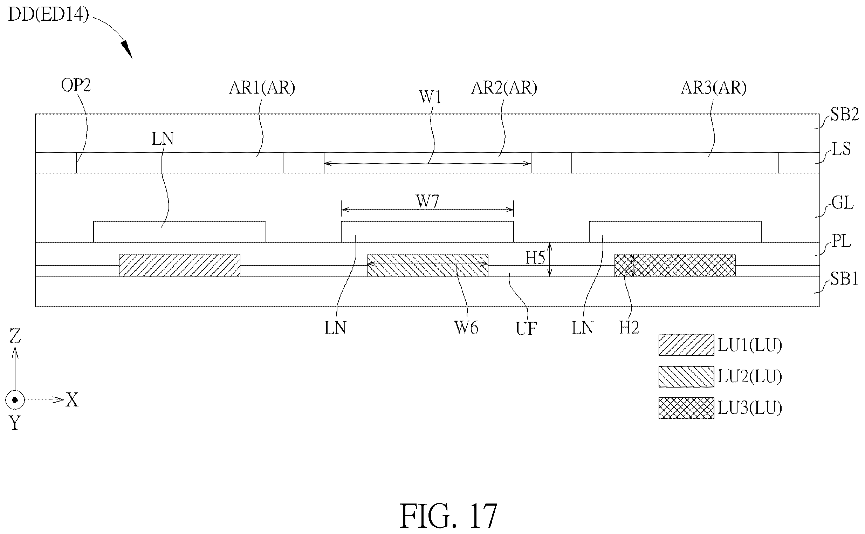

Referring to FIG. 17, FIG. 17 schematically illustrates a cross-sectional view of an electronic device according to a variant embodiment of the fifth embodiment of the present disclosure. In the present variant embodiment, the electronic device ED14 may include the first substrate SB1, the light emitting units LU, the underfill layer UF and the planarization layer PL. The light emitting units LU may be directly disposed on the first substrate SB1, the underfill layer UF may be directly disposed on the first substrate SB1 and surround the light emitting units LU, and the planarization layer PL may be disposed on the underfill layer UF and cover the light emitting units LU, but not limited thereto. In the present embodiment, the distance H5 between the top surface of the planarization layer PL and the top surface of the first substrate SB1 may be greater than, equal to or less than the height H2 of the light emitting unit LU. The electronic device ED14 may further include the lens units LN, wherein the lens units LN may respectively be disposed corresponding to one of the light emitting units LU. The lens unit LN may include metalens, and the details thereof may refer to the contents mentioned above. The electronic device ED14 may further include a glue material GL disposed on the lens units LN. The glue material GL may be directly disposed on the planarization layer PL and cover the lens units LN, but not limited thereto. The glue material GL may include optical clear adhesive (OCA) or optical clear resin (OCR), but not limited thereto. The electronic device ED14 may further include the light shielding layer LS and the anti-reflection layers AR disposed on the glue material GL. The light shielding layer LS may be directly disposed on the glue material GL and include the plurality of openings OP2, and the anti-reflection layers AR may respectively be disposed corresponding to the light emitting units LU in the openings OP2, but not limited thereto. The features of the light shielding layer LS and the anti-reflection layers AR may refer to the contents mentioned above. The electronic device ED14 may further include the second substrate SB2 disposed on the light shielding layer LS and the anti-reflection layers AR. According to the present embodiment, in a cross-sectional view of the electronic device ED14, the width of an anti-reflection layer AR may be greater than or equal to the width of a lens unit LN to which the anti-reflection layer AR corresponds, and the width of the lens unit LN may be greater than or equal to the width of a light emitting unit LU to which the lens unit LN corresponds. For example, as shown in FIG. 17, the width of the anti-reflection layer AR2 (such as the width W1 mentioned above) may be greater than or equal to the width W7 of the lens unit LN corresponding to the light emitting unit LU2, and the width W7 may be greater than or equal to the width of the light emitting unit LU2 (such as the width W6 mentioned above).

Referring to FIG. 18, FIG. 18 schematically illustrates a top view of an electronic device according to a sixth embodiment of the present disclosure. Specifically, FIG. 18 shows the arrangement of the light emitting units LU (or the pixels PX) and the microlenses ML of the electronic device ED15 of the present embodiment. In order to simplify the figure, FIG. 18 just shows the light emitting units LU and the microlenses ML in the electronic device ED15, and other elements and layers are omitted. According to the present embodiment, the light emitting units LU and the microlenses ML of the electronic device ED15 may be arranged in a string shape or a strip shape. For example, the light emitting units LU and the microlenses ML may respectively extend along the direction X and the direction Y and be arranged in an array. Several examples of the light emitting units LU and the microlenses ML of the electronic device ED15 arranged in a string shape or a strip shape are shown in the following.

In some embodiments, in a pixel PX of the electronic device ED15, each sub-pixel SPX of a color may include two light emitting units LU. In detail, as shown in the structure (I) of FIG. 18, a pixel PX of the electronic device ED15 may include a sub-pixel SPX1, a sub-pixel SPX2 and a sub-pixel SPX3, wherein the sub-pixel SPX1 may include two light emitting units LU1, the sub-pixel SPX2 may include two light emitting units LU2, and the sub-pixel SPX3 may include two light emitting units LU3. In other words, six light emitting units LU may be included in a pixel PX. The light emitting unit LU1, the light emitting unit LU2 and the light emitting unit LU3 may for example emit red light, green light and blue light respectively, that is, the sub-pixel SPX1, the sub-pixel SPX2 and the sub-pixel SPX3 may respectively be a red sub-pixel, a green sub-pixel and a blue sub-pixel. The two light emitting units LU1 in the sub-pixel SPX1 may be connected to each other in series, the two light emitting units LU2 in the sub-pixel SPX2 may be connected to each other in series, and the two light emitting units LU3 in the sub-pixel SPX3 may be connected to each other in series. In a pixel PX, the two light emitting units LU1 in the sub-pixel SPX1, the two light emitting units LU2 in the sub-pixel SPX2, and the two light emitting units LU3 in the sub-pixel SPX3 may respectively be arranged along the direction Y, and the light emitting unit LU1, the light emitting unit LU2 and the light emitting unit LU3 may be arranged along the direction X, but not limited thereto. The plurality of pixels PX in the electronic device ED15 may also extend along the direction X and the direction Y and be arranged in an array. In such condition, the light emitting units LU arranged along the direction Y may be the light emitting units LU of the same color, and the light emitting units LU1, the light emitting units LU2 and the light emitting units LU3 may be arranged along the direction X alternately. In the electronic device ED15, the microlenses ML may respectively correspond to one of the light emitting units LU. Therefore, the arrangement of the microlenses ML may be the same as the arrangement of the light emitting units LU. In a top view of the electronic device ED15, the center of a microlens ML may overlap the center of the light emitting layer of the light emitting unit LU to which the microlens ML corresponds, but not limited thereto.

According to the present embodiment, among the plurality of light emitting units LU of the same color arranged along the direction Y, the distances between the centers of the light emitting layers of any two adjacent light emitting units LU may be the same. For example, as shown in the structure (I) of FIG. 18, a distance F1 is included between the center of the light emitting layer of a light emitting unit LU1 (in the pixel PX1) and the center of the light emitting layer of another light emitting unit LU1 (in the pixel PX1) adjacent to the light emitting unit LU1, and a distance F2 is included between the center of the light emitting layer of the another light emitting unit LU1 and the center of the light emitting layer of yet another light emitting unit LU1 (in the pixel PX3 adjacent to the pixel PX1 in the direction Y) adjacent to the another light emitting unit LU1, wherein the distance F1 and the distance F2 may be the same. In other words, the light emitting units LU of the same color arranged along the direction Y may be distributed at the same intervals. It should be noted that although it is not shown in the figure, the distribution of the light emitting units LU1 mentioned above may be applied to the distribution of the light emitting units LU2 and the distribution of the light emitting units LU3. In addition, among the plurality of light emitting units LU arranged along the direction X, the distances between the centers of the light emitting layers of any two adjacent light emitting units may be the same. For example, as shown in the structure (I) of FIG. 18, a distance F3 is included between the center of the light emitting layer of a light emitting unit LU1 (in the pixel PX1) and the center of the light emitting layer of a light emitting unit LU2 (in the pixel PX1) adjacent to the light emitting unit LU1, a distance F4 is included between the center of the light emitting layer of the light emitting unit LU2 and the center of the light emitting layer of a light emitting unit LU3 (in the pixel PX1) adjacent to the light emitting unit LU2, and a distance F5 is included between the center of the light emitting layer of the light emitting unit LU3 and the center of the light emitting layer of another light emitting unit LU1 (in the pixel PX2 adjacent to the pixel PX1 in the direction X) adjacent to the light emitting unit LU3, wherein the distance F3, the distance F4 and the distance F5 may be the same. In other words, the light emitting units LU1, the light emitting units LU2 and the light emitting units LU3 alternately disposed along the direction X may be distributed at the same intervals. Moreover, according to the present embodiment, in any two pixels PX adjacent to each other in the direction X or the direction Y, the distance between the centers of the light emitting layers of two light emitting units LU located at the same relative position may be fixed. In detail, as shown in the structure (I) of FIG. 18, the distance between the center of the light emitting layer of the light emitting unit LU1 located at the upper left in the pixel PX1 and the center of the light emitting layer of the light emitting unit LU1 located at the upper left in the pixel PX2 adjacent to the pixel PX1 in the direction X may be the same as the distance between the center of the light emitting layer of the light emitting unit LU1 located at the upper left in the pixel PX1 and the center of the light emitting layer of the light emitting unit LU1 located at the upper left in the pixel PX3 adjacent to the pixel PX1 in the direction Y. In other words, the sum of the distance F1 and the distance F2 may be the same as the sum of the distance F3, the distance F4 and the distance F5 (that is, F1+F2=F3+F4+F5). The above-mentioned feature may be applied to other light emitting units LU in the pixels PX. It should be noted that the distance F1, the distance F2, the distance F3, the distance F4 and the distance F5 mentioned above may also be the distances between the centers of two adjacent microlenses ML.

In some embodiments, as shown in the structure (II) of FIG. 18, a pixel PX of the electronic device ED15 may include a sub-pixel SPX1, a sub-pixel SPX2, a sub-pixel SPX3 and three spare sub-pixels RX (including a spare sub-pixel RX1, a spare sub-pixel RX2 and a spare sub-pixel RX3). The sub-pixel SPX1, the sub-pixel SPX2 and the sub-pixel SPX3 may respectively include a light emitting unit LU1, a light emitting unit LU2 and a light emitting unit LU3. The light emitting unit LU1, the light emitting unit LU2 and the light emitting unit LU3 for example emit red light, green light and blue light respectively, that is, the sub-pixel SPX1, the sub-pixel SPX2 and the sub-pixel SPX3 may respectively be a red sub-pixel, a green sub-pixel and a blue sub-pixel. The spare sub-pixel RX1, the spare sub-pixel RX2 and the spare sub-pixel RX3 may respectively correspond to one of the openings OP1 of the light absorbing layer AB (not shown in FIG. 18) mentioned above. Specifically, the openings OP1 corresponding to the spare sub-pixels RX may expose the conductive elements (such as the bonding pads) of the circuit layer, but no light emitting unit LU is disposed in these openings OP1. In a pixel PX, the spare sub-pixel RX1 may be electrically connected to the sub-pixel SPX1, or in other words, the spare sub-pixel RX1 may be electrically connected to the light emitting unit LU1 in the sub-pixel SPX1. Specifically, the spare sub-pixel RX1 may be connected in parallel with the sub-pixel SPX1 (or the light emitting unit LU1). "The spare sub-pixel RX1 is electrically connected to the sub-pixel SPX1" described herein may include the embodiment that the bonding pads corresponding to the spare sub-pixel RX1 are electrically connected to the bonding pads corresponding to the sub-pixels SPX1 (or the light emitting unit LU1), but not limited thereto. Similarly, the spare sub-pixel RX2 may be connected in parallel with the sub-pixel SPX2 (or the light emitting unit LU2), and the spare sub-pixel RX3 may be connected in parallel with the sub-pixel SPX3 (or the light emitting unit LU3). The spare sub-pixel RX1 may serve as a repairing sub-pixel of the sub-pixel SPX1, that is, the spare sub-pixel RX1 may be referred to as a red spare sub-pixel. Similarly, the spare sub-pixel RX2 may serve as a repairing sub-pixel of the sub-pixel SPX2, which is referred to as a green spare sub-pixel, and the spare sub-pixel RX3 may serve as a repairing sub-pixel of the sub-pixel SPX3, which is referred to as a blue spare sub-pixel. For example, in a repairing step of the light emitting units LU, if it is detected that a light emitting unit LU1 in the sub-pixel SPX1 of a pixel PX is damaged, a red light emitting unit may be disposed in the spare sub-pixel RX1 as a repairing light emitting unit. In the present embodiment, the sub-pixels SPX and the spare sub-pixels RX of the same color may be alternately arranged along the direction Y, but not limited thereto. In addition, the sub-pixels SPX1, the sub-pixels SPX2 and the sub-pixels SPX3 may be alternately arranged along the direction X. Similarly, the spare sub-pixels RX1, the spare sub-pixels RX2 and the spare sub-pixels RX3 may be alternately arranged along the direction X. Moreover, in the present embodiment, the microlenses ML of the electronic device ED15 may be disposed corresponding to each of the sub-pixels SPX and each of the spare sub-pixels RX. Specifically, the microlenses ML may respectively be disposed corresponding to the light emitting units LU in the sub-pixels SPX, and the microlenses ML may further be disposed corresponding to one of the spare sub-pixels RX respectively. In a top view of the electronic device ED15, the center of a microlens ML may overlap the center of the light emitting layer of the light emitting unit LU to which the microlens ML corresponds, but not limited thereto. In addition, when the microlens ML is disposed corresponding to the spare sub-pixel RX, the relative position between the microlens ML and the spare sub-pixel RX may refer to the relative position between the microlens ML and the light emitting unit LU in the sub-pixel SPX. For example, in a top view of the electronic device ED15, the center of a microlens ML may overlap the geometric center of the shape enclosed by the outer edge of the bonding pads in the spare sub-pixel RX to which the microlens ML corresponds, but not limited thereto.

In the present embodiment, the distance F1 and the distance F2 mentioned above may for example be defined as the distance between the centers of the microlenses ML respectively corresponding to a sub-pixel SPX and a spare sub-pixel RX of the same color and adjacent to each other in the direction Y, and the distance F3, the distance F4 and the distance F5 mentioned above may for example be defined as the distance between the centers of the microlenses ML respectively corresponding to the sub-pixels SPX (or the spare sub-pixels RX) adjacent to each other in the direction X. The relationship between the distance F1, the distance F2, the distance F3, the distance F4 and the distance F5 may refer to the contents mentioned above, and will not be redundantly described.

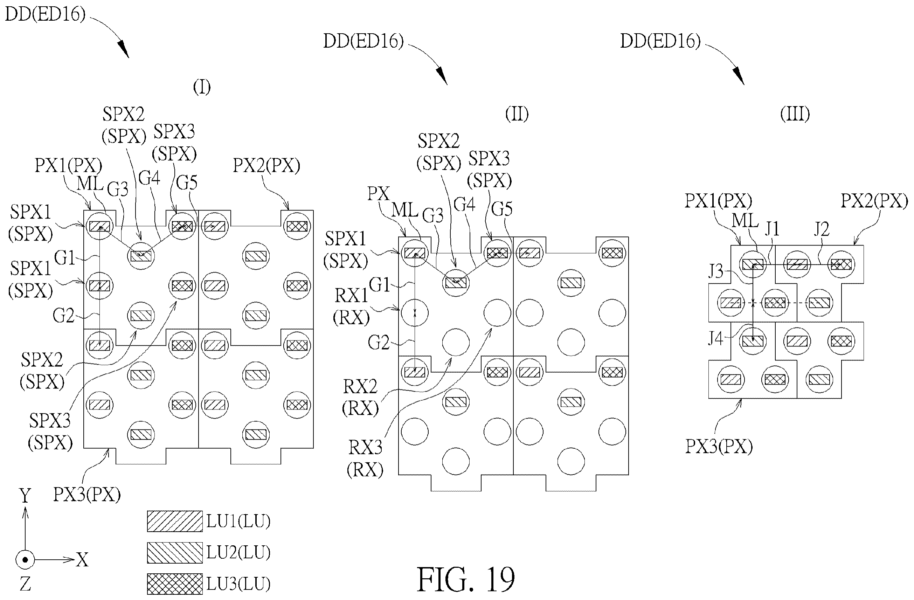

Referring to FIG. 19, FIG. 19 schematically illustrates a top view of an electronic device according to a seventh embodiment of the present disclosure. FIG. 19 shows the arrangement of the light emitting units LU (or the pixels PX) and the microlenses ML in the electronic device ED16 of the present embodiment. In order to simplify the figure, FIG. 19 just shows the light emitting units LU and the microlenses ML in the electronic device ED16, and other elements and layers are omitted. According to the present embodiment, the light emitting units LU and the microlenses ML of the electronic device ED16 may be arranged in a triangle (or having a delta arrangement). Several examples of the light emitting units LU and the microlenses ML of the electronic device ED16 arranged in a triangle are shown in the following.

In some embodiments, as shown in the structure (I) of FIG. 19, a pixel PX of the electronic device ED16 may include a sub-pixel SPX1, a sub-pixel SPX2 and a sub-pixel SPX3, wherein the sub-pixel SPX1 may include two light emitting units LU1, the sub-pixel SPX2 may include two light emitting units LU2, and the sub-pixel SPX3 may include two light emitting units LU3. In other words, six light emitting units LU may be included in a pixel PX. The features and the electrical connection relationship of the sub-pixels SPX may refer to related description of the structure (I) in FIG. 18, and will not be redundantly described. In the present embodiment, the six light emitting units LU in a pixel PX may be arranged in triangles. For example, in a pixel PX, the light emitting unit LU1, the light emitting unit LU2 and the light emitting unit LU3 in the upper row and the light emitting unit LU1, the light emitting unit LU2 and the light emitting unit LU3 in the lower row may respectively be arranged in an inverted triangle, and the light emitting units LU of the same color may be arranged along the direction Y, but not limited thereto. In other embodiments, the light emitting units LU in a pixel PX may be arranged in two triangles. In such condition, in a pixel PX, the two light emitting units LU1 and the two light emitting units LU2 may be misaligned with each other in the direction Y, and the two light emitting units LU2 and the two light emitting units LU3 may be misaligned with each other in the direction Y. In the present embodiment, the arrangements of the light emitting units LU in each pixel PX of the electronic device ED16 may be the same. The microlenses ML may respectively be disposed corresponding to the light emitting units LU. Therefore, the arrangement of the microlenses ML may be the same as the arrangement of the light emitting units LU, that is, the triangle arrangement (or delta arrangement) mentioned above. By making the microlenses ML have the triangle arrangement (or delta arrangement), the spatial configuration of the electronic device ED16 may be improved. In a top view of the electronic device ED16, the center or a microlens ML may overlap the center of the light emitting layer of the light emitting unit LU to which the microlens ML corresponds, but not limited thereto. It should be noted that the arrangement of the light emitting units LU mentioned above may for example be achieved by adjusting the pattern of the light absorbing layer AB (or the arrangement of the openings OP1).

According to the present embodiment, among the plurality of light emitting units LU of the same color arranged along the direction Y, the distances between the centers of the light emitting layers of any two adjacent light emitting units may be the same. For example, as shown in the structure (I) of FIG. 19, a distance G1 is included between the center of the light emitting layer of a light emitting unit LU1 (in the pixel PX1) and the center of the light emitting layer of another light emitting unit LU1 (in the pixel PX1) adjacent to the light emitting unit LU1, and a distance G2 is included between the center of the light emitting layer of the another light emitting unit LU1 and the center of the light emitting layer of yet another light emitting unit LU1 (in the pixel PX3 adjacent to the pixel PX1 in the direction Y) adjacent to the another light emitting unit LU1, wherein the distance G1 and the distance G2 may be the same. In other words, the light emitting units LU of the same color arranged along the direction Y may be distributed at the same intervals. In addition, in a pixel PX, the distance between the centers of the light emitting layers of two light emitting units LU having different colors and adjacent to each other may be fixed. For example, as shown in the structure (I) of FIG. 19, taking the pixel PX1 as an example, a distance G3 is included between the center of the light emitting layer of a light emitting unit LU1 and the center of the light emitting layer of a light emitting unit LU2 adjacent to the light emitting unit LU1, and a distance G4 is included between the center of the light emitting layer of the light emitting unit LU2 and the center of the light emitting layer of a light emitting unit LU3 adjacent to the light emitting unit LU2, wherein the distance G3 and the distance G4 may be the same. It should be noted that a distance G5 is included between the center of the light emitting layer of a light emitting unit LU3 in the pixel PX1 and the center of the light emitting layer of a light emitting unit LU1 (in the pixel PX2) adjacent to the light emitting unit LU3, wherein the distance G5 may be the same as or different from the distance G3 (or the distance G4). It should be noted that the distance G1, the distance G2, the distance G3, the distance G4 and the distance G5 mentioned above may also be the distance between the centers of two adjacent microlenses ML.

In some embodiments, as shown in the structure (II) of FIG. 19, a pixel PX of the electronic device ED16 may include a sub-pixel SPX1, a sub-pixel SPX2, a sub-pixel SPX3 and three spare sub-pixels RX (including a spare sub-pixel RX1, a spare sub-pixel RX2 and a spare sub-pixel RX3). The features of the spare sub-pixels RX and the electrical connection relationship between the spare sub-pixels RX and the sub-pixels SPX may refer to related description of the structure (II) in FIG. 18, and will not be redundantly described. According to the present embodiment, in a pixel PX, the light emitting unit LU1, the light emitting unit LU2 and the light emitting unit LU3 may be arranged in an inverted triangle, the spare sub-pixel RX1, the spare sub-pixel RX2 and the spare sub-pixel RX3 may also be arranged in an inverted triangle, and the light emitting units LU and the spare sub-pixels RX of the same color may be arranged along the direction Y, but not limited thereto. In addition, the arrangement of the light emitting units LU in each pixel PX may be the same. The microlenses ML may be disposed corresponding to the light emitting units LU and the spare sub-pixels RX. Therefore, the arrangement of the microlenses ML may be the same as the arrangement of the light emitting units LU and the spare sub-pixels RX, that is, the triangle arrangement (or delta arrangement) mentioned above. In a top view of the electronic device ED16, the center of a microlens ML may overlap the center of the light emitting layer of the light emitting unit LU to which the microlens ML corresponds, but not limited thereto. In addition, the center of a microlens ML may overlap the geometric center of the shape enclosed by the outer edge of the bonding pads in the spare sub-pixel RX to which the microlens ML corresponds, but not limited thereto.

In the present embodiment, the distance G1 and the distance G2 mentioned above may for example be defined as the distance between the centers of the microlenses ML respectively corresponding to a sub-pixel SPX and a spare sub-pixel RX of the same color and adjacent to each other in the direction Y, and the distance G3, the distance G4 and the distance G5 mentioned above may for example be defined as the distance between the centers of the microlenses ML respectively corresponding to two adjacent sub-pixels SPX (or two adjacent spare sub-pixels RX) of different colors. The relationship between the distance G1, the distance G2, the distance G3, the distance G4 and the distance G5 may refer to the contents mentioned above, and will not be redundantly described.

In some embodiments, as shown in the structure (III) of FIG. 19, a pixel PX of the electronic device ED16 may include three light emitting units LU which are respectively be the light emitting unit LU1, the light emitting unit LU2 and the light emitting unit LU3. According to the present embodiment, in a pixel PX (such as the pixel PX1), the light emitting unit LU1, the light emitting unit LU2 and the light emitting unit LU3 may be arranged in a triangle; in another pixel PX (such as the pixel PX3) adjacent to the pixel PX in the direction Y, the arrangement of the light emitting units LU may be the same as the arrangement of the light emitting units LU in the pixel PX, and in yet another pixel PX (such as the pixel PX2) adjacent to the pixel PX1 in the direction X, the light emitting unit LU1, the light emitting unit LU2 and the light emitting unit LU3 may be arranged in an inverted triangle. In other words, the light emitting units LU in the pixels PX arranged along the direction X may be arranged alternately in a triangle and in an inverted triangle; and the light emitting units LU in the pixels PX arranged along the direction Y may be arranged in a triangle or in an inverted triangle. Through the above-mentioned arrangement design, the light emitting units LU1, the light emitting units LU2 and the light emitting units LU3 may be alternately arranged in a row of light emitting units LU in a direction X, and in the direction Y, a column of light emitting units LU and another column of light emitting units LU adjacent to the column of light emitting units LU may be misaligned with each other. The microlenses ML may be disposed corresponding to the light emitting units LU, that is, the arrangement of the microlenses ML may be the same as the arrangement of the light emitting units LU. In such condition, the compactness of the arrangement of the microlenses ML may increase, thereby improving the spatial configuration of the electronic device ED16.

According to the present embodiment, among the plurality of light emitting units LU arranged along the direction X, the distances between the centers of the light emitting layers of any two adjacent light emitting units LU may be the same. For example, as shown in the structure (III) of FIG. 19, a distance J1 is included between the center of the light emitting layer of a light emitting unit LU2 (in the pixel PX1) and the center of the light emitting layer of a light emitting unit LU1 (in the pixel PX2) adjacent to the light emitting unit LU2, and a distance J2 is included between the center of the light emitting layer of the light emitting unit LU1 and the center of the light emitting layer of a light emitting unit LU3 (in the pixel PX2) adjacent to the light emitting unit LU1, wherein the distance J1 and the distance J2 may be the same. In addition, in the direction Y, the distance between the centers of the light emitting layers of two light emitting units LU of the same color and adjacent to each other may be fixed. "The two light emitting units of the same color and adjacent to each other" described herein may indicate any two light emitting units LU having the minimum distance in the direction Y among the light emitting units LU of the same color in the electronic device ED16. For example, as shown in the structure (III) of FIG. 19, the light emitting unit LU2 in the pixel PX1 and the light emitting unit LU2 in the pixel PX2 may be regarded as the two light emitting units LU of the same color and adjacent to each other, and the light emitting unit LU2 in the pixel PX2 and the light emitting unit LU2 in the pixel PX3 may also be regarded as the two light emitting units LU of the same color and adjacent to each other. Specifically, a distance J3 may be included between the center of the light emitting layer of the light emitting unit LU2 in the pixel PX1 and the center of the light emitting layer of the light emitting unit LU2 in the pixel PX2 in the direction Y, and a distance J4 may be included between the center of the light emitting layer of the light emitting unit LU2 in the pixel PX2 and the center of the light emitting layer of the light emitting unit LU2 in the pixel PX3 in the direction Y, wherein the distance J3 and the distance J4 may be the same. The definitions and relationship of the distance J3 and the distance J4 may be applied to other light emitting units LU, such as the light emitting units LU1 and the light emitting units LU3.

In summary, an electronic device is provided by the present disclosure, wherein the electronic device includes light emitting units, a light absorbing layer and microlenses. The light absorbing layer may define the disposition position of the light emitting units, and the microlenses may be disposed corresponding to the light emitting units. Through the designs of structures, arrangements or sizes of the layers or the elements in the electronic device, the light emitting effect of the electronic device may be improved, or the electronic device may have a narrow viewing angle without disposing other layers additionally.

## Claims

1. An electronic device (ED), **characterized by** comprising:
a substrate (SB1);
a light emitting unit (LU) disposed on the substrate (SB1) and used to emit a light (L1);
a microlens (ML) disposed corresponding to the light emitting unit (LU) and used to concentrate the light (L1); and
a light absorbing layer (AB), wherein the light absorbing layer (AB) defines a light channel (LH) located between the light emitting unit (LU) and the microlens (ML), and the light channel (LH) is used to guide the light (L1) to the microlens (ML),
wherein a length (N1) of the light channel (LH) is greater than or equal to 60% of a distance (N2) between the light emitting unit (LU) and the microlens (ML).

2. The electronic device of claim 1, **characterized in that** in a cross-sectional view of the electronic device, a width (W5) of the light channel (LH) is greater than a width (W6) of the light emitting unit (LU).

3. The electronic device of claim 1, **characterized in that** in a cross-sectional view of the electronic device, a width (W5) of the light channel (LH) is less than or equal to a width (W2) of the microlens (ML).

4. The electronic device of claim 3, **characterized in that** a difference between the width (W5) of the light channel (LH) and the width (W2) of the microlens (ML) ranges from 5 micrometers to 15 micrometers.

5. The electronic device of claim 1, **characterized in that** in a cross-sectional view of the electronic device, a center of a light emitting region of the light emitting unit (LU) deviates from a center of the microlens (ML).

6. The electronic device of any one of claim 1 to claim 5, **characterized in that** in a normal direction of the electronic device, the microlens (ML) at least partially overlaps the light absorbing layer (AB).

7. The electronic device of any one of claim 1 to claim 6, **characterized by** further comprising an underfill layer (UF) disposed on the substrate (SB1), wherein the underfill layer (UF) surrounds the light emitting unit (LU).

8. The electronic device of claim 7, **characterized by** further comprising a first material layer (M1) disposed on the underfill layer (UF), wherein a refractive index of the first material layer (M1) is greater than 1.0 and less than or equal to 1.8.

9. The electronic device of claim 8, **characterized by** further comprising a material layer (MM) disposed on the first material layer (M1), wherein a refractive index of the material layer (MM) is greater than or equal to 1.0 and less than or equal to a refractive index of the microlens (ML).

10. The electronic device of claim 8 or 9, **characterized by** further comprising a second material layer (M2) disposed on the first material layer (M1), wherein a refractive index of the first material layer (M1) is less than or equal to a refractive index of the second material layer (M2).

11. An electronic device (ED8), **characterized by** comprising:
a substrate (SB1);
a light emitting unit (LU) disposed on the substrate (SB1) and used to emit a light;
a microlens (ML) disposed corresponding to the light emitting unit (LU) and used to concentrate the light; and
a light absorbing layer (AB), wherein the light absorbing layer (AB) defines a light channel (LH), and the microlens (ML) is disposed in the light channel (LH),
wherein a length (N1) of the light channel (LH) is greater than or equal to a height (H4) of the microlens (ML).

12. The electronic device of claim 11, **characterized by** further comprising a first material layer (M1) and a second material layer (M2), wherein the first material layer (M1) is disposed on the substrate (SB1), the second material layer (M2) is disposed on the first material layer (M1), and a refractive index of the first material layer (M1) is less than or equal to a refractive index of the second material layer (M2).

13. The electronic device of claim 11 or claim 12, **characterized by** further comprising an anti-reflection layer (AR) disposed corresponding to the light emitting unit (LU), wherein the microlens (ML) is disposed on the anti-reflection layer (AR).

14. The electronic device of claim 13, **characterized in that** in a cross-sectional view of the electronic device, a width (W1) of the anti-reflection layer (AR) is less than or equal to a width (W2) of the microlens (ML).

15. The electronic device of any one of claim 11 to claim 14, **characterized by** further comprising:
a second substrate (SB2) located on the light absorbing layer (AB); and
a material layer (MM) located between the second substrate (SB2) and the microlens (ML),
wherein a refractive index of the material layer (MM) is greater than or equal to 1.0 and less than or equal to a refractive index of the microlens (ML).
